# EUROPÄISCHE PATENTSCHRIFT

(11) **EP 3 523 824 B1**
(45) Veröffentlichungstag und Bekanntmachung des Hinweises auf die Patenterteilung: **05.05.2021**
(21) Anmeldenummer: 17791940.4
(22) Anmeldetag: 06.10.2017
(51) Int. Cl.: H01L 23/10, H01L 23/498, H01L 23/538

(54) **GEHÄUSE FÜR EIN PRIMÄRES ELEKTRONISCHES BAUTEIL, MIT EINEM SEKUNDÄREN ELEKTRONISCHEN BAUTEIL IM DECKEL ODER BODEN DES GEHÄUSES**
HOUSING FOR A PRIMARY ELECTRONIC COMPONENT, HAVING A SECONDARY ELECTRONIC COMPONENT EMBEDDED WITHIN THE COVER OR BASE OF THE HOUSING
BOITIER POUR UN COMPOSANT ELECTRONIQUE PRIMAIRE, AVEC UN COMPOSANT ELECTRONIQUE SECONDAIRE DANS LE COUVERCLE OU LE BAS DU BOITIER

(30) Priorität: 06.10.2016 DE 102016011934; 06.10.2016 DE 202016006195 U
(43) Veröffentlichungstag der Anmeldung: 14.08.2019
(73) Patentinhaber: Possehl Electronics Deutschland GmbH, 75223 Niefern (DE)
(72) Erfinder: KURZEJA, Dietmar, 75223 Niefern (DE)
(74) Vertreter: Leitner, Waldemar
(86) Internationale Anmeldenummer: PCT/EP2017/025302
(87) Internationale Veröffentlichungsnummer: WO 2018/065121

(56) Entgegenhaltungen:
- DE-A1- 19 800 928
- US-A1- 2002 114 143
- US-B1- 6 300 679

## Beschreibung

Die Erfindung betrifft ein Gehäuse zur Aufnahme eines elektronischen Bauteils einer elektronischen Baugruppe gemäß den Merkmalen des Oberbegriffs des Anspruchs 1, eine elektronische Baugruppe gemäß den Merkmalen des Obergriffs des Anspruchs 9, ein Verfahren zur Herstellung eines Gehäuses gemäß den Merkmalen des Oberbegriffs des Anspruchs 11 und ein Verfahren zur Herstellung einer elektronischen Baugruppe gemäß den Merkmalen des Obergriffs des Anspruchs 14.

Derartige elektronische Baugruppen werden oft durch eine sogenannte Nacktchipmontage hergestellt, das heißt, es werden ungehäuste, elektronische Bauteile, insbesondere ungehäuste Halbleiter-Chips, auf einem Träger, insbesondere auf einer starren Leiterplatte oder einer flexiblen Trägerfolie, direkt montiert. Der Hauptvorteil eines derartigen Verfahrens sind die geringen Herstellungskosten, was insbesondere bei einer Massenproduktion von elektronischen Baugruppen von Vorteil ist. Diese Nacktchipmontage, oft als Chip-On-Bord-Technologie (COB) bezeichnet, besitzt des weiteren den Vorteil, dass ungehäuste elektronische Bauteile einen geringeren Platzbedarf aufweisen als bereits vor der Montage gehäuste, so dass eine höhere Bauteildichte auf dem Träger der elektronischen Baugruppe ermöglicht ist. Insbesondere dann, wenn derartig hergestellte elektronische Bauteilegruppen in einer rauhen Umgebung eingesetzt werden, ist es aber erforderlich, die ungehäusten elektronischen Bauteile zu kapseln. Bekannte Vorgehensweisen hierzu sind ein Vergießen der Nacktchips, insbesondere mit Duroplasten, ein Vorsehen einer Schutzkappe oder das Aufbringen einer die gesamte elektronische Baugruppe überdeckenden Schutzschicht.

Nachteilig daran ist unter anderem, dass eine derartige Verkapselung des oder der auf einem Träger der elektronischen Baugruppe angeordneten elektronischen Bauteile es erschwert, wenn nicht unmöglich macht, defekte elektronische Bauteile auszutauschen und damit die elektronische Baugruppe zu reparieren. Auch sind nachträgliche anwendungsbezogene Anpassungen der elektronischen Baugruppe nicht oder nur schwer möglich.

Ein weiterer Nachteil einer derartigen Verkapselung ist, dass sie nur zur Abschirmung des darin aufgenommenen Bauteils einer elektronischen Baugruppe gegen Umwelteinflüsse dient. Eine weitergehende Funktion weisen die bekannten Gehäuse nicht auf. Dies ist insbesondere im Hinblick auf die Bauteildichte nachteilig: Wie vorstehend ausgeführt, werden derart gekapselte elektronische Bauteile auf einem Träger montiert, auf dem nur ein begrenzter Raum zur Verfügung steht. Da - wie vorstehend ausgeführt - ein gekapseltes elektronisches Bauteil einen höheren Platzbedarf aufweist als ein Nackt-Chip, wird die Bauteildichte auf dem Träger der elektronischen Baugruppe durch die Verwendung eines wie vorstehend beschrieben ausgebildeten Gehäuses reduziert. Es besteht daher das Bedürfnis, auch bei in einem Gehäuse aufgenommenen elektronischen Bauteilen die Bauteildichte zu erhöhen, also den von dem Gehäuse auf dem Träger der elektronischen Baugruppe eingenommenen Raum besser zu nutzen.

Aus der US 2002/114143 A1 ist eine Anordnung von elektronischen Komponenten bekannt, die dadurch entsteht, dass eine biegsame rechteckige streifenförmige Struktur, vorzugsweise ein Polymer-Film, aufeinandergefaltet wird. Es handelt sich bei der in der vorgenannten Druckschrift beschriebenen Struktur um eine sogenannte "Flip-Chip-On-Film-Assembly", also um eine Anordnung, mit der gekapselte elektronische Chips auf einen dünnen Film angeordnet und über auf dem Film angeordnete Leiterbahnen verbunden werden. Dieser dünne Film erlaubt es dann, dass ein erster Bereich des dünnen Film, der ein erstes gekapseltes Bauteil enthält, und einen zweiten Bereich, der ein weiteres gekapseltes Bauteil enthält, um einen flexiblen Bereich der Struktur gefaltet werden kann, so dass die vorgenannte vertikale Konfiguration erzielbar ist. Es handelt sich also bei der Struktur der vorgenannten Druckschrift nicht um ein Gehäuse, sondern um einen meanderförmig zusammenlegbaren Streifen, mittels dessen gekapselte elektronische Bauteile miteinander elektrisch verbunden übereinander anordbar sind.

Die US 6 300 679 B1 beschreibt eine vergleichbare Struktur. Auch hier wird ein Substrat verwendet, welches Teil eines Bands ist. Dieses Substrat weist einen Mittelbereich auf, welcher gegenüberliegende Endbereiche verbindet, so dass das Substrat um den Halbleiter-Chip gefaltet werden kann, indem das Substrat entlang einer Linie so gefaltet wird, dass ein erster Endbereich des Substrats über einem zweiten Endbereich liegt. Im Substrat ist eine Schicht aus Leiterbahnen angeordnet, wobei die Leiterbahnen sich auf den Mittelbereich erstrecken und in den Endbereichen enden.

Die DE 692 09 772 T2 beschreibt eine Anordnung zur Gehäusebildung um eine Funktionseinrichtung, z. B. um ein Halbleiterelement, ein auf einem Halbleiter basierendes Element, ein Sensorelement, ein Mikrostellglied oder eine elektronische Schaltung bestehend aus einer oder mehreren integrierten Schaltungen und anderen elektronischen Bauteilen, wobei das Gehäuse zwei Gehäusehälften besitzt, die mindestens einen verschlossenen Hohlraum bilden, der die vorgenannte Funktionseinrichtung entweder ganz oder teilweise umgibt. Es sind Metallteile vorgesehen, die durch die Wände des Gehäuses verlaufen und Drahtverbindungen zu der vom Gehäuse umgebenen Funktionseinrichtung bilden. Der Hohlraum ist abgedichtet und mit einem elektrisch isolierenden Fluid gefüllt. Hierbei ist vorgesehen, dass das Gehäuse aus einer thermoplastischen Kunststoff-Formmasse hergestellt und zumindest Teile der den Hohlraum umgebenden Wände des Gehäuses nachgiebig gestaltet sind, um Expansionskräfte des elektrisch isolierenden Fluids aufzunehmen. Gemäß einem Ausführungsbeispiel dieses Gehäuses ist vorgesehen, dass das Gehäuse aus einer Basiskomponente und einer Deckelkomponente geformt ist, welche durch ein Scharnier miteinander verbunden sind. Die Drahtverbindung zur Kontaktierung der im Gehäuse aufgenommenen Funktionseinrichtung ist in der Basiskomponente eingeformt. Die beiden vorgenannten Komponenten sind mittels Klebstoffs oder Schweißens aneinander befestigt und das elektrisch isolierende Fluid wird in Form einer Flüssigkeit oder einer Gelsubstanz über Füll-Löcher in den dadurch gebildeten Hohlraum des Gehäuses eingeleitet.

Die US 5,041,696 A beschreibt ein Gehäuse für ein elektronisches Bauteil, das einen tassenförmigen Basisteil und einen Deckelteil aufweist, wobei diese beiden Teile über ein Scharnierelement miteinander verbunden sind. Zum Schließen des Gehäuses wird der Deckelteil auf das Basisteil geklappt und mit diesem dichtend verbunden.

Die US 2006/077644 A1 beschreibt eine elektronische Vorrichtung, welche ein erstes elektronisches Bauteil und zweites elektronisches Bauteil aufweist, welche mechanisch und elektrisch durch ein faltbares Substrat und einen Zwischenverdrahtungsträger des ersten elektronischen Bauteiles verbunden sind. Zur Herstellung der Vorrichtung wird auf den Boden des Substrats das erste elektronische Bauteil aufgesetzt, welches über Drähte mit dem Anschlussbereich des Bodenteils des Substrats verbunden ist. Diese Bereiche werden dann mit Zwischenverbindungsbereichen des Bodenbereichs des Substrats mittels Drähten verbunden. Dann wird der Zwischenverdrahtungsträger auf den Bodenbereich des Substrats aufgesetzt und seine Verbindungselemente werden mit den Zwischenverbindungsbereichen des Substrats verbunden. Dann wird der Deckelbereich des Substrats gefaltet, was bewirkt, dass die Verbindungselemente des Substrats mit den vorgenannten Zwischenverbindungsbereichen in elektronischen Kontakt treten. Dann wird der Innenbereich des Zwischenverdrahtungsträgers mit einer Epoxidschicht ausgefüllt, um das elektrische Bauteil zu verkapseln.

Aus der US 2009/065921 A1 ist eine Vorgehensweise bekannt, elektronische Bauteile unterschiedlicher Größe in einem größeren Bauteil aufzunehmen. Auch hier ist ein Zwischen- oder Umverdrahtungsträger vorgesehen, welcher Leiterbahnstrukturen aufweist. Dieser Zwischenverdrahtungsträger wird um das elektronische Bauteil herumgelegt und bildet somit eine Art Adapter zwischen diesen beiden Bauteilen aus. Die Verkapselung des elektronischen Bauteils kann hierdurch nicht erreicht werden.

Die JP 2751518 B2 beschreibt eine biegbare Leiterplatte, auf der Halbleiterelemente angeordnet sind. Die Halbleiterplatte trägt Verstärkungsplatten, welche jeweils eine Öffnung aufweisen, in der die elektronischen Bauteile aufgenommen sind. Diese Öffnungen werden dann durch Harze aufgefüllt.

Die JP 2002009234 A beschreibt ebenfalls eine biegbare Leiterplatte, welche einen im Wesentlichen rechteckigen Basisbereich aufweist, an welchen sich um den Basisbereich klappbare Montagebereiche anschließen. Auf jeden diese Montagebereiche ist ein Abstandshalter angeordnet, in dessen Innenraum elektronische Bauteile aufgenommen sind.

Die DE 198 00 928 A1 beschreibt ein Gehäuse zur Aufnahme von Bauelementen sowie ein Verfahren zu dessen Herstellung. Das Gehäuse umfasst eine Abdeckung und eine Grundplatte, wobei die Abdeckung und die Grundplatte durch eine Leiterplatte einstückig ausgebildet sind. Die Leiterplatte weist des Weiteren einen flexiblen Bereich auf und ist in diesem Bereich derart gebogen, dass die Abdeckung und die Grundplatte einander überliegend angeordnet sind. Hierbei ist vorgesehen, dass zwischen der Abdeckung und der Grundplatte ein Abstandshalteelement angeordnet ist, weiches als ein starrer Rahmen ausgebildet ist. Die Rahmenhöhe ist hierbei so gewählt, dass der minimal mögliche Biegeradius der flexiblen Folie, welche den Boden, den Deckel und den zwischen diesen beiden Komponenten liegenden flexiblen Bereich ausbildet, nicht überschritten und die benötigte Einbauhöhe der in diesem Gehäuse aufzunehmenden Bauelemente erreicht wird. Zur besseren Ausgestaltung dieses flexiblen Bereichs der Leiterplatte ist der Abstandshalter an den Biegestellen mit Aussparungen versehen, sodass die flexible Folie nach dem Zusammenklappen die äußeren Abmessungen des Gehäuses nicht überschreitet und ferner mechanisch geschützt ist.

Es ist daher Aufgabe der Erfindung, ein Gehäuse für eine elektronische Baugruppe zu schaffen, welches eine verbesserte Ausnutzung des durch das erfindungsgemäße Gehäuse eingenommenen Raums ermöglicht und in einfacher und daher kostengünstiger Weise eine Verkapselung des im erfindungsgemäßen Gehäuse aufgenommenen elektronischen Bauteils erlaubt. Außerdem soll eine derartige elektronische Baugruppe, ein Verfahren zur Herstellung des erfindungsgemäßen Gehäuses und ein Verfahren zur Herstellung der elektronischen Baugruppe vorgeschlagen werden.

Diese Aufgabe wird erfindungsgemäß durch ein Gehäuse mit den Merkmalen des Kennzeichens des Anspruchs 1, eine elektronische Baugruppe gemäß den Merkmalen des Kennzeichens des Anspruchs 9, ein Verfahren zur Herstellung des erfindungsgemäßen Gehäuses gemäß den kennzeichnenden Merkmalen des Anspruchs 11 und ein Verfahren zur Herstellung einer elektronischen Baugruppe gemäß den kennzeichnenden Merkmalen des Anspruchs 14 gelöst.

Durch die erfindungsgemäßen Maßnahmen wird in vorteilhafter Art und Weise ein Gehäuse ausgebildet, welches in einfacher Art und Weise eine Verkapselung eines elektronischen Bauteils einer elektronischen Baugruppe ermöglicht. Die Erfindung sieht in vorteilhafter Art und Weise vor, dass der Boden und/oder der Deckel des Gehäuses funktionalisierbar ist, indem im Boden und/oder im Deckel sekundäre elektronische Bauteile wie eine Antenne, Anzeigen, etc. angeordnet sind. Da erfindungsgemäß vorgesehen ist, dass im erfindungsgemäßen Gehäuse ein Leadframe mit mindestens einer Leiterbahn, die im Boden des Gehäuses angeordnet ist, und mindestens einer weiteren Leiterbahn, die im Deckel des Gehäuses angeordnet ist, wobei sich die mindestens eine Leiterbahn vom Boden des Gehäuses ausgehend über das Scharnierelement bis zum Deckel des Gehäuses erstreckt, vorgesehen sind, ist eine elektrisch leitende Verbindung zwischen dem oder den im Gehäuse aufgenommenen primären elektronischen Bauteilen und dem oder den vorgenannten sekundären elektronischen Bauteilen ermöglicht. Eine derartige Maßnahme besitzt den Vorteil, dass hierdurch in vorteilhafter Art und Weise die Funktionalität eines im erfindungsgemäßen Gehäuse befindlichen elektronischen Bauteils und/oder einer dieses Gehäuse verwendenden elektronischen Baugruppe erhöhbar ist. Indem nun erfindungsgemäß vorgesehen ist, dass an der Unterseite des Deckels und/oder an der Oberseite des Bodens jeweils ein umlaufender Rand angeordnet wird, wird in vorteilhafter Art und Weise ein Gehäuse für eine elektronische Baugruppe geschaffen, welches eine verbesserte Ausnutzung des durch das erfindungsgemäße Gehäuse eingenommenen Raums ermöglicht und in einfacher und daher kostengünstiger Weise eine Verkapselung des im erfindungsgemäßen Gehäuse aufgenommenen elektronischen Bauteils erlaubt.

Eine vorteilhafte Weiterbildung der Erfindung sieht vor, dass das Gehäuse mindestens einen Trägerkörper aufweist, dessen erster Bereich den Boden und sein zweiter Bereich den Deckel des Gehäuses ausbilden, wobei vorzugsweise vorgesehen ist, dass über dem Trägerkörper ein Deckkörper angeordnet ist, dessen erster und dessen zweiter Bereich über dem ersten und dem zweiten Bereich des Trägerkörpers angeordnet sind. Eine derartige Maßnahme besitzt den Vorteil einer besonderen einfachen Herstellung des Gehäuses.

Eine weitere vorteilhafte Weiterbildung der Erfindung sieht vor, dass der Trägerkörper und vorzugsweise auch der Deckkörper einen zwischen dem jeweiligen ersten und zweiten Bereich liegenden flexiblen mittleren Bereich aufweist, welcher zusammen mit den vom Boden zum Deckel des Gehäuses verlaufenden Leiterbahnen des Leadframes das Schanierelement ausbilden.

Eine weitere vorteilhaft Weiterbildung der Erfindung sieht vor, dass das Schanierelement durch Leiterbahnen des Leadframes ausgebildet ist. Eine derartige Maßnahme besitzt den Vorteil einer besonders einfachen Herstellbarkeit des Gehäuses.

Eine weitere vorteilhafte Weiterbildung der Erfindung sieht vor, dass der Boden und/oder der Deckel des erfindungsgemäßen Gehäuses mindestens eine Kontaktöffnung besitzt, über die das im Gehäuse aufgenommene elektronische Bauteil elektrisch kontaktierbar ist. Eine derartige Maßnahme besitzt den Vorteil, dass hierdurch elektronische Baugruppen über- oder nebeneinander angeordnet werden können. Insbesondere das Übereinanderordnen mehrerer das erfindungsgemäße elektronische Gehäuse verwendender elektronischer Baugruppen besitzt den Vorteil, dass hierdurch eine höhere Bauteildichte auf einem Träger, insbesondere einer Leiterplatte, erzielbar ist.

Die erfindungsgemäße elektronische Baugruppe zeichnet sich dadurch aus, dass der Boden und/oder Deckel des Gehäuses funktionalisiert ist, in dem im Boden und/oder im Deckel ein oder mehrere sekundäre elektronische Bauteile angeordnet sind.

Weitere vorteilhafte Weiterbildungen der Erfindung sind Gegenstand der Unteransprüche.

Weitere Einzelheiten und Vorteile der Erfindung sind den Ausführungsbeispielen zu entnehmen, die im Folgenden anhand der Figuren beschrieben werden. Es zeigen:
- Figuren 1a und 1b: zwei perspektivische Darstellungen eines ersten Ausführungsbeispiels eines Gehäuses zur Aufnahme eines elektronischen Bauteils jeweils ohne ein elektronisches Bauteil, **welches als solches nicht Gegenstand der beanspruchten Erfindung ist,**
- Figuren 2a und 2b: das erste Ausführungsbeispiel der Figuren 1a und 1b, zusammen mit einem in dieses Gehäuse eingesetzten elektronischen Bauteil,
- Figuren 3a-3c: eine Draufsicht, eine Seitenansicht und eine Unteransicht des ersten Ausführungsbeispiels in einem nicht-geklappten Zustand des Gehäuses,
- Figuren 4a-4d: eine Draufsicht, ein Schnitt entlang der Linie A-A der Figur 4a, eine Unteransicht und eine vergrößerte Darstellung des Bereichs A der Figur 4b in geklapptem Zustand,
- Figuren 5a-5e: schematische Darstellung des Herstellungsprozesses des ersten Ausführungsbeispiels,
- Figuren 6a und 6b: zwei perspektivische Darstellungen eines zweiten Ausführungsbeispiels eines Gehäuses, jeweils ohne das elektronische Bauteil,
- Figuren 7a und 7b: das zweite Ausführungsbeispiel der Figuren 5a und 5b, zusammen mit einem in dieses Gehäuse eingesetzten elektronischen Bauteil,
- Figuren 8a-8c: eine Draufsicht, eine Seitenansicht und eine Unteransicht des zweiten Ausführungsbeispiels in einem nicht-geklappten Zustand des Gehäuses,
- Figuren 9a-9d: eine Draufsicht, einen Schnitt entlang der Linie A-A der Figur 9a, eine Unteransicht, und eine vergrößerte Darstellung des Bereichs A der Figur 9b in geklapptem Zustand,
- Figuren 10a-10e: eine schematische Darstellung der Herstellung des zweiten Ausführungsbeispiels,
- Figuren 11a und 11b: zwei perspektivische Darstellungen eines dritten Ausführungsbeispiels eines Gehäuses, jeweils ohne ein elektronisches Bauteil,
- Figuren 12a und 12b: das dritte Ausführungsbeispiel der Figuren 11a und 11b, zusammen mit einem elektronischen Bauteil,
- Figuren 13a-13c: eine Draufsicht, eine Seitenansicht und eine Unteransicht des dritten Ausführungsbeispiels in einem nicht-geklappten Zustand des Gehäuses,
- Figuren 14a-14d: eine Draufsicht, einen Schnitt entlang der Linie A-A der Figur 14a, eine Unteransicht, und eine vergrößerte Darstellung des Bereichs A der Figur 14b in geklapptem Zustand,
- Figuren 15a-15e: eine schematische Darstellung der Herstellung des dritten Ausführungsbeispiels,
- Figuren 16a und 16b: zwei perspektivische Darstellungen eines vierten Ausführungsbeispiels eines Gehäuses, jeweils ohne ein elektronisches Bauteil,
- Figuren 17a und 17b: das vierte Ausführungsbeispiel der Figuren 16a und 16b, zusammen mit einem elektronischen Bauteil,
- Figuren 18a-18c: eine Draufsicht, eine Seitenansicht und eine Unteransicht des vierten Ausführungsbeispiels in einem nicht-geklappten Zustand des Gehäuses,
- Figuren 19a-19d: eine Draufsicht, einen Schnitt entlang der Linie A-A der Figur 19a, eine Unteransicht, und eine vergrößerte Darstellung des Bereichs A der Figur 19b,
- Figuren 20a-20e: eine schematische Darstellung der Herstellung des vierten Ausführungsbeispiels,
- Figuren 21a und 21b: zwei perspektivische Darstellungen eines fünften Ausführungsbeispiels eines Gehäuses, jeweils ohne ein elektronisches Bauteil,
- Figuren 22a und 22b: das fünfte Ausführungsbeispiel der Figuren 21 a und 21 b, zusammen mit einem elektronischen Bauteil,
- Figuren 23a-23c: eine Draufsicht, eine Seitenansicht und eine Unteransicht des fünften Ausführungsbeispiels in einem nicht-geklappten Zustand des Gehäuses,
- Figuren 24a-24d: eine Draufsicht, einen Schnitt entlang der Linie A-A der Figur 24a, eine Unteransicht, und eine vergrößerte Darstellung des Bereichs A der Figur 24b,
- Figuren 25a-25e: eine schematische Darstellung der Herstellung des fünften Ausführungsbeispiels,
- Figuren 26a und 26b: eine erste Ausführungsform einer aus mehreren elektronischen Baugruppen ausgebildeten Mehrfach-Anordnung,
- Figuren 27a und 27b: eine zweite Ausführungsform einer aus mehreren elektronischen Baugruppen ausgebildeten Mehrfach-Anordnung,
- Figuren 28a-28d: perspektivische Darstellungen eines sechsten Ausführungsbeispiels eines Gehäuses, jeweils ohne ein elektronisches Bauteil,
- Figuren 29a-29c: eine Draufsicht, eine Seitenansicht und eine Unteransicht dieses sechsten Ausführungsbeispiels in einem nicht-geklappten Zustand des Gehäuses,
- Figuren 30a-30d: eine Draufsicht, einen Schnitt entlang der Linie A-A der Figur 30a, eine Unteransicht und eine vergrößerte Darstellung des Bereichs A der Figur-30b.

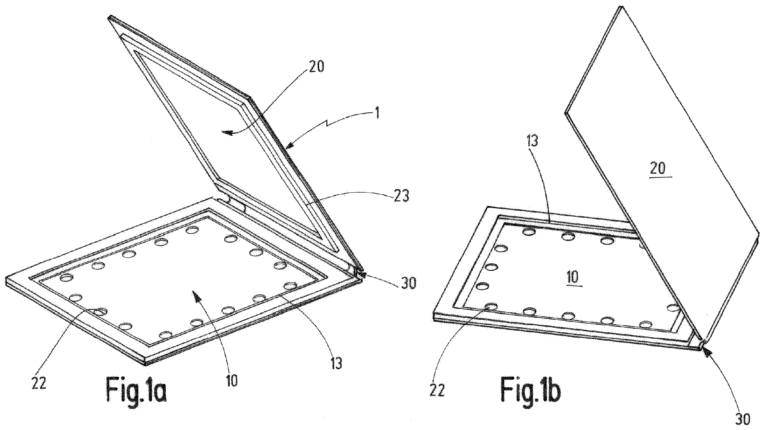

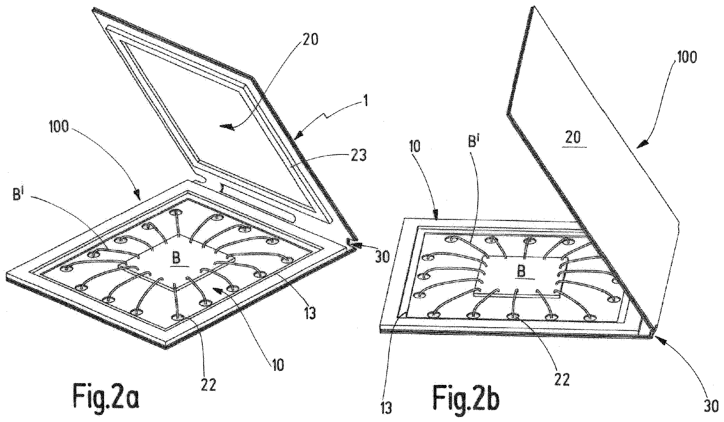

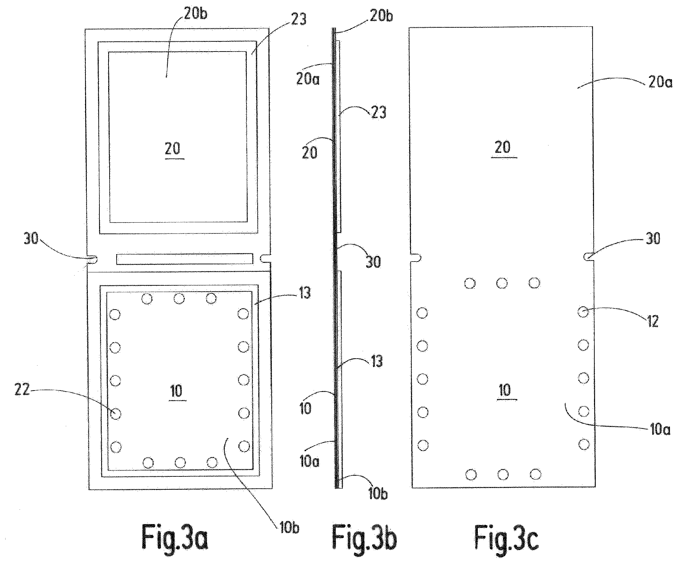

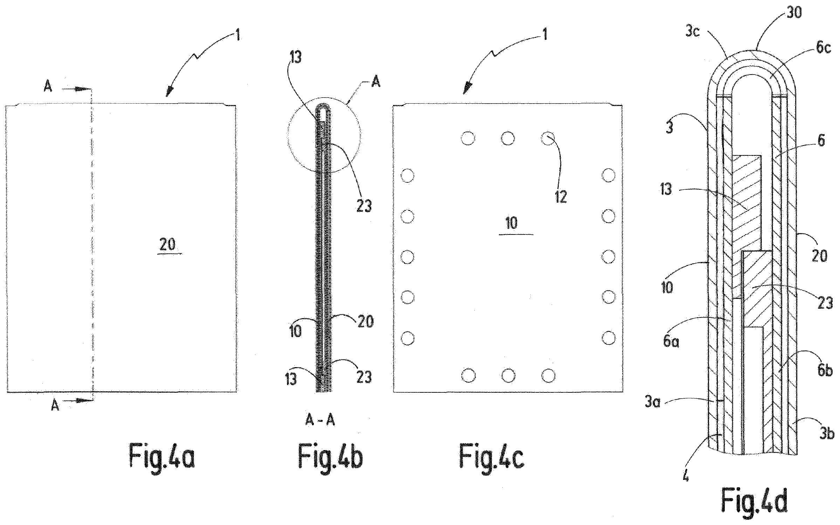

In den Figuren 1a bis 5e ist schematisch ein erstes Ausführungsbeispiel, welches als solches nicht Gegenstand der beanspruchten Erfindung ist, eines allgemein mit 1 bezeichneten Gehäuses für ein elektronisches Bauteil B, insbesondere einen Halbleiter-Chip (in den Figuren 1a und 1b nicht gezeigt) dargestellt, wobei die Figuren 1a und 1b eine perspektivische Ansicht des Gehäuses 1 in einem teilweise geklappten Zustand ohne das elektronische Bauteil, die Figuren 2a und 2b das Gehäuse 1 mit dem elektronischen Bauteil B, die Figur 3a eine Draufsicht auf das ungefaltete Gehäuse 1, die Figur 3b eine Seitenansicht und die Figur 3c eine Unteransicht des Gehäuses 1 zeigt. Die Figur 4a zeigt eine Draufsicht auf das Gehäuse 1 in zusammengeklapptem Zustand, die Figur 4b einen Schnitt entlang der Linie A-A der Figur 4a, die Figur 4c eine Unteransicht des geklappten Gehäuses 1 und die Figur 4d eine vergrößerte Darstellung des Bereichs A der Figur 4b. Die weiteren Ausführungsbeispiele sind - sofern nicht besonders darauf hingewiesen wird - in der gleichen Art und Weise dargestellt, so dass bei diesen auf eine erneute Erläuterung der in den einzelnen Figuren grundsätzlich dargestellten Ansichten weitgehend verzichtet wird.

Das Gehäuse 1 weist einen Boden 10 und einen Deckel 20 auf, die über ein Scharnierelement 30 miteinander verbunden sind. Wie aus der Figur 1 ersichtlich, weist der Boden 10 des Gehäuses 1 vorzugsweise einen Freiraum 2 auf, in dem das elektronische Bauteil aufnehmbar ist. Im Boden 10 - wie am besten aus den Figuren 3c und 4c ersichtlich ist - ist eine Anzahl von Kontaktöffnungen 12 vorgesehen, durch welche - wie nachstehend beschrieben - eine elektrische Kontaktierung des in dem Gehäuse 1 aufgenommen elektronischen Bauteils B (siehe Figuren 2a und 2b) von seiner unteren Kontaktfläche, also von der Unterseite 10a des Bodens 10, ermöglicht ist. Der Boden 10 weist eine Anzahl von Anschlussöffnungen 22 auf, welche den Anschluss des im Gehäuse 1 eingesetzten elektronischen Bauteils B über Bonddrähte B' ermöglichen. Es ist für den Fachmann offensichtlich, dass es natürlich möglich ist, die Bonddrähte B' ganz oder teilweise durch andere Kontaktierungsmittel zu ersetzen; es ist z. B. auch möglich, das elektronische Bauteil B durch eine Löttechnik zu kontaktieren, um nur eine aus der Vielzahl der möglichen Anschlusstechniken hier zu erwähnen. Da es aber nicht darauf ankommt, wie das elektronische Bauteil B durch die Anschlussöffnungen 22 kontaktiert ist, wird im folgenden der Einfachheit halber davon ausgegangen, dass dieses elektronische Bauteil B - wie vorstehend beschrieben - über Bonddrähte B' kontaktiert wird.

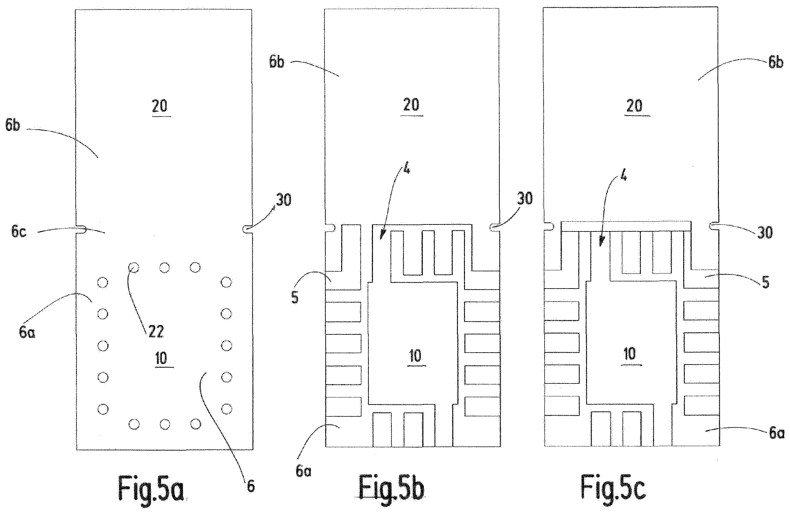

Leiterbahnen 5 eines Leadframes 4 erstrecken sich von den Anschlussöffnungen 22 zu den Kontaktöffnungen 12 (siehe Figuren 5b bis 5e), so dass durch eine elektrische Kontaktierung der Leiterbahnen 5 durch die Kontaktöffnungen 12 hindurch über die Leiterbahnen 5 des Leadframes eine elektrisch leitende Verbindung zu dem im Gehäuse 1 aufgenommenen elektronischen Bauteil B ermöglicht ist. Am Boden 10 des Gehäuses 1 ist an seiner Oberseite 10b, also an der im gefalteten Zustand des Gehäuses 1 innenliegenden Seite, ein umlaufender Rand 13 vorgesehen. Der Deckel 20 weist an seiner Unterseite 20b, also an seiner im gefalteten Zustand des Gehäuses 1 wiederum innenliegenden Seite, einen entsprechenden umlaufenden Rand 23 auf, der im geschlossenen Zustand des Gehäuses 1 mit dem umlaufenden Rand 13 des Bodens 10 zusammenwirkt: Wird das Gehäuse 1 geschlossen, indem der Deckel 20 um das Scharnierelement 30 geklappt wird, so treten der umlaufende Rand 13 des Bodens 10 und der umlaufende Rand 23 des Deckels 20 miteinander in Kontakt, wodurch eine Abdichtung des Gehäuses 1 in seinem Seitenbereich erzielt ist.

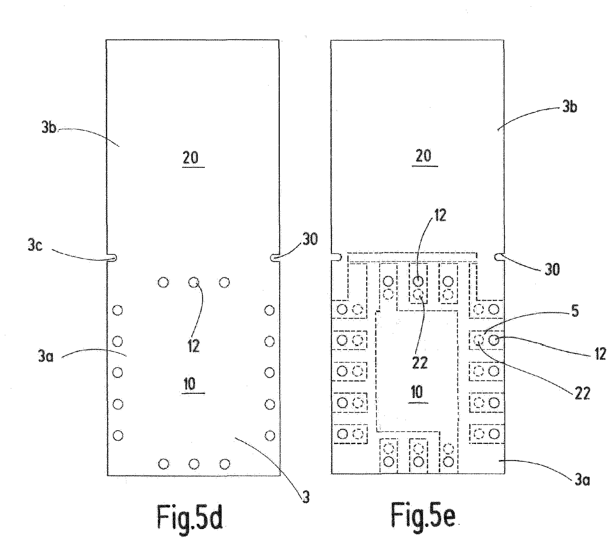

Weitere Einzelheiten, und insbesondere konstruktive und funktionale Ausgestaltungen des Gehäuses 1 werden nachfolgend anhand eines exemplarischen Herstellungsprozesses dieses Gehäuses 1 anhand der Figuren 5a bis 5e beschrieben. Die vorgenannten Figuren zeigen den - auch aus Figur 4e erkennbaren - schichtweisen Aufbau des Gehäuses 1, welches einen Trägerkörper 3 (Figur 5d) und einen Deckkörper 6 (Figur 5a) aufweist. Zwischen diesen beiden Lagen des Gehäuses 1 ist der Leadframe 4 mit Leiterbahnen 5 angeordnet. Die Herstellung des Gehäuses 1 aus den vorgenannten Komponenten ist schematisch in den Figuren 5a bis 5e dargestellt, wobei die Herstellung eines derartig mehrlagigen Aufbaus an und für sich bekannt ist und daher nicht mehr im Detail beschrieben werden muss. Die Figur 5a zeigt eine Draufsicht auf den flexiblen Deckkörper 6 des Gehäuses 1, vorzugsweise wird hierzu eine flexible Trägerfolie verwendet. Ein in Figur 5a unterer Bereich 6a dieses flexiblen Deckkörpers 6 bildet dann zusammen mit einem entsprechenden Bereich 3a des Trägerkörpers 3 den Boden 10 des Gehäuses 1 und ein in Figur 5a oberer Bereich 6b bildet zusammen mit einem Bereich 3b des Trägerkörpers 3 dessen Deckel 20 aus. Das Scharnierelement 30, welches den Boden 10 und den Deckel 20 verbindet, wird durch einen mittleren Bereich 3c des Trägerkörpers 3 und eines Bereichs 6c des Deckkörpers 6 ausgebildet. Man erkennt aus der Figur 5a, dass in den den Boden 10 des Gehäuses 1 ausbildenden ersten Bereich 6a des Deckkörpers 3 bereits die Anschlussöffnungen 22 eingebracht sind, welche - wie bereits vorstehend erwähnt - die elektrische Kontaktierung des im Gehäuse 1 aufgenommenen elektronischen Bauteils mit den Leiterbahnen 5 eines Leadframes 4 ermöglichen.

Wie in Figur 5b dargestellt, wird auf dem Deckkörper 6 des Gehäuses 1 nun der in dieser Figur nur schematisch dargestellter Leadframe 4 angeordnet, insbesondere durch eine Laminiertechnik. Eine derartige Vorgangsweise ist bekannt und muss daher nicht näher beschrieben werden. Dann werden einzelne Bereiche des Leadframes 4 getrennt, um einzelne Leiterbahnen 5 auszubilden (siehe Figur 5c). Diese Leiterbahnen 5 führen jeweils von den Anschlussöffnungen 22 (in den Figuren 5b und 5c nicht gezeigt) zu den Kontaktöffnungen 12 (siehe Figur 5e) und somit dem im Gehäuse 1 aufgenommenen elektronischen Bauteil B, welches bei der Endmontage des wie nachstehend beschrieben ausgestalteten Gehäuses 1 und des elektronischen Bauteils zur elektronischen Baugruppe durch eine entsprechende Anschlusstechnik mit den Leiterbahnen 5 verbunden ist.

Die genaue Ausgestaltung und Führung der Leiterbahnen 5 ist vom jeweiligen Anwendungszweck, insbesondere von dem im Gehäuse 1 aufgenommenen Bauteil abhängig und wird in der Regel anwendungsspezifisch festgelegt. Auch dies ist bekannt und muss daher nicht beschrieben werden.

Die Figur 5d zeigt nun eine Draufsicht auf einen flexiblen Trägerkörper 3 des Gehäuses 1, welcher zur Ausbildung des Gehäuses 1 über die durch den Deckkörper 6 und den auf ihm angeordneten Leadframe 4 gegebene Struktur angeordnet wird. Hierbei wird wiederum bevorzugt, dass die Verbindung des Trägerkörpers 3 des Gehäuses 1 mit dem Deckkörper 6 und den auf diesem liegenden Leadframe 4 durch ein Laminieren erfolgt. Der untere Bereich 3a des Trägerkörpers 3 liegt über dem unteren Bereich 6a des Deckkörpers 6 und bildet zusammen mit diesem den hier zweilagig ausgebildeten Boden 10 des Gehäuses 1 aus. In entsprechender Art und Weise liegt der obere Bereich 3b des Trägerkörpers 3 über dem oberen Bereich 6b des Deckkörpers 6 und bildet zusammen mit diesem den hier zweilagig ausgebildeten Deckel 20 aus. Der mittlere Bereich 3c des Trägerkörpers 3 liegt über dem mittleren Bereich 6c des Deckkörpers 6 und bildet zusammen mit diesem das Scharnierelement 30 des Gehäuses 1 aus.

Man erkennt aus der Figur 5d die im Trägerkörper 3 vorgesehenen Kontaktöffnungen 12, welche zum Anschluss des im Gehäuse 1 aufgenommenen elektronischen Bauteils dienen. Die Leiterbahnen 5 reichen im hier beschriebenen Ausführungsbeispiel somit von den Anschlussöffnungen 22 zu den Kontaktöffnungen 12 des Bodens 1 des Gehäuses 1.

Die Figur 5e zeigt nun eine Draufsicht auf das wie vorstehend beschrieben ausgebildete Gehäuse 1, wobei die unter dem Trägerkörper 3 liegenden Strukturen strichliert dargestellt sind.

In einem darauffolgenden Arbeitsschritt werden die wie bereits vorstehend angesprochenen umlaufenden Ränder 13 und 23 des Bodens 10 und des Deckels 20 des Gehäuses 1 ausgebildet, indem auf die im gefalteten Zustand des Gehäuses 1 innenliegende Oberfläche 6b des Deckkörpers 6 eine die Ränder 13 bzw. 23 ausbildende Struktur aufgebracht wird. Bevorzugt wird, dass zur Ausbildung der Ränder 13 und 23 ein duroplastischer Kunststoff verwendet wird.

Zur Ausbildung einer elektronischen Baugruppe wird dann das elektronische Bauteil, insbesondere ein Halbleiter-Chip, hierbei insbesondere ein Nackt-Chip, in den Innenraum der Gehäuse 1 eingebracht und seine elektrischen Anschlüsse werden durch eine entsprechende Anschlussverbindungstechnik mit den entsprechenden Anschlussflächen des Gehäuses 1, also den durch die Anschlussöffnungen des Grundkörpers 2 zugängliche Bereiche der Leiterbahnen den Leadframes 3 verbunden. Dann wird der Deckel 20 um das Scharnierelement 4 auf das Gehäuse 10 geklappt und diese beiden Hälften der Gehäuse 1 verbunden und entsprechend verschlossen. Die derartig ausgebildete elektronische Baugruppe kann dann in einfacher Art und Weise auf einem entsprechenden Träger, insbesondere einer starren Leiterplatte, angeordnet werden.

Die beschriebene Vorgangsweise besitzt den Vorteil, dass hierdurch in einfacher Art und Weise ein Gehäuse 1, welches eine Kapselung für ein ungehäustes elektronisches Bauteil, insbesondere einen ungehäusten Halbleiter-Chip (Nackt-Chip) ausbildet, geschaffen wird, das einfach und daher kostengünstig herzustellen ist. Da das Gehäuse 1 zum späteren Zeitpunkt leicht wieder geöffnet werden kann, ist ein Austausch, z. B. für eine Reparatur, eines in dem Gehäuse 1 aufgenommenen elektronischen Bauteils leicht möglich.

Die beschriebene Konstruktion erlaubt es in vorteilhafter Art und Weise auch, das Gehäuse 1 für das elektronische Bauteil zu funktionalisieren, indem vorzugsweise in den Deckel 20 Kontaktelemente und/oder aktive und/oder passive elektronische Bauelemente integriert werden. Es ist hierdurch möglich, dass - wie anhand der nachfolgenden Ausführungsbeispiele beschrieben - z.B. eine drahtlose Kommunikation zwischen dem im Gehäuse 1 aufgenommenen elektronischen Bauteil und einen oder mehreren Peripheriegeräten ermöglicht wird, dass in den Deckel 20 z.B. Anzeige- oder Kontrollelemente integriert werden, oder dass durch die im Deckel 20 vorgesehenen Kontaktelemente eine Kontaktierung zwischen mehreren derartig aufgebauten elektronischen Baugruppen ermöglicht wird. Im Sinne einer einfachen Unterscheidung der vorgenannten Bauteile von im Gehäuse 1 aufgenommenen "primären" elektronischen Bauteil werden die vorstehend genannten, im Deckel 20 vorgesehenen Kontaktelemente, aktiven und/oder passiven elektronischen Bauteile auch als "sekundäre elektronische Bauteile" bezeichnet.

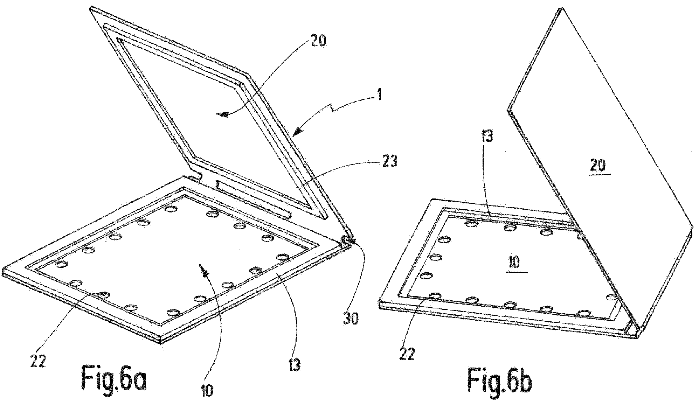

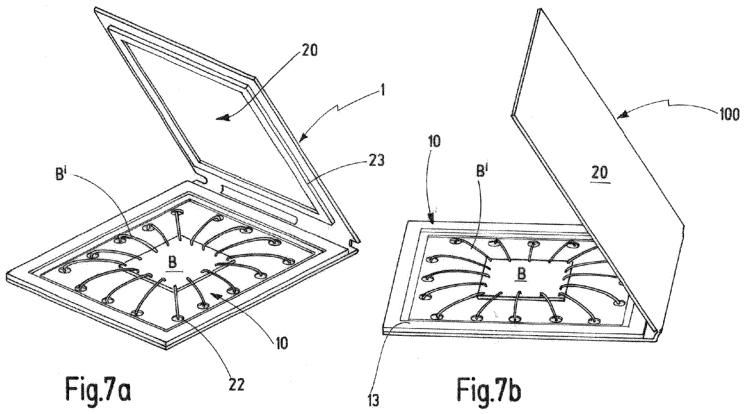

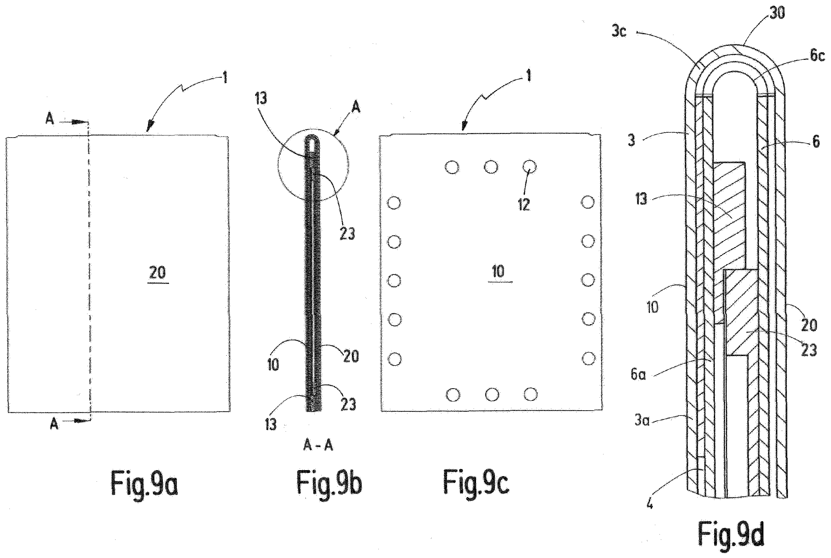

In den Figuren 6a bis 10e ist ein zweites Ausführungsbeispiel eines Gehäuses 1 für eine elektronische Baugruppe 100 dargestellt, welches in seinem Grundaufbau nach demjenigen des ersten Ausführungsbeispiels entspricht. Einander entsprechende Bauteile/Strukturen werden daher mit gleichen Bezugszeichen versehen und nicht mehr weiter im Detail beschrieben. Die Figuren 6a und 6b zeigen das zweite Ausführungsbeispiel des Gehäuses 1 im geöffneten Zustand, die Figuren 7a und 7b dieses Gehäuse 1 zusammen mit einem elektronischen Bauteil B, welches über Bonddrähte B' angeschlossen ist, indem die Bonddrähte B' durch die Anschlussöffnungen 22 des Bodens 10 des Gehäuses 1 hindurch geführt und mit den durch diese Anschlussöffnungen 22 zugänglichen Anschlussbereichen den Leiterbahnen 5 des Leadframes 4 verbunden sind, so dass die elektronische Baugruppe 100 ausgebildet ist. Insoweit unterscheidet sich also diesbezüglich der Aufbau des Gehäuses 1 des zweiten Ausführungsbeispiels nicht von demjenigen des ersten Ausführungsbeispiels.

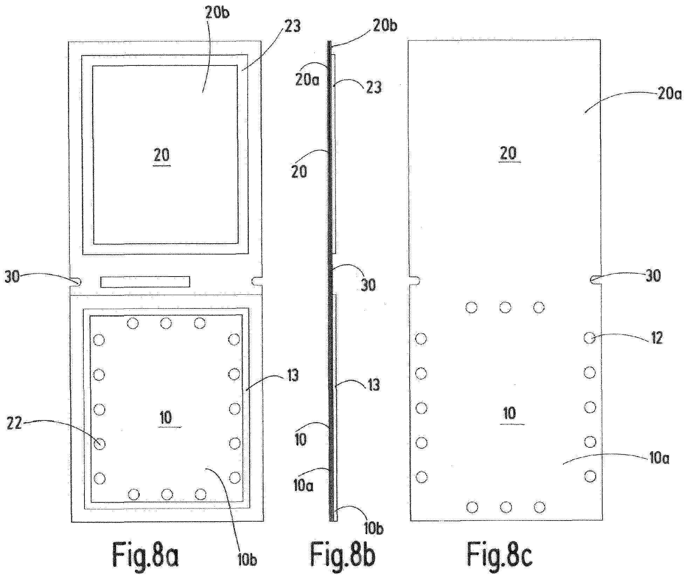

Die Figur 8a zeigt eine Draufsicht auf das gefaltete Gehäuse 1 des zweiten Ausführungsbeispiels, die Figur 8b einen Schnitt entlang der Linie A-A der Figur 8a, die Figur 8c eine Ansicht des Gehäuses 1 von dessen Kontaktseite her und die Figur 8d eine vergrößerte Darstellung des Details A der Figur 8b. Man erkennt aus den letztgenannten Figuren wiederum den schichtweisen Aufbau des Gehäuses 1 sowie das Zusammenwirken der Ränder 13 und 23 des Bodens 10 und des Deckels 20.

Der wesentliche Unterschied zwischen dem ersten und dem zweiten Ausführungsbeispiel ist nun, dass im Deckel 20 - als ein sekundäres elektronisches Bauteil - eine Antenne A integriert ist, welche eine drahtlose Kommunikation des im Gehäuse 1 aufgenommenen Bauteils B mit Peripheriegeräten ermöglicht, und dass - wie nachstehend beschrieben - das im Boden 10 angeordnete primäre elektronische Bauteil mit dem im Deckel 20 angeordneten sekundären elektronischen Bauteil über den Leadframe 4 verbunden sind.

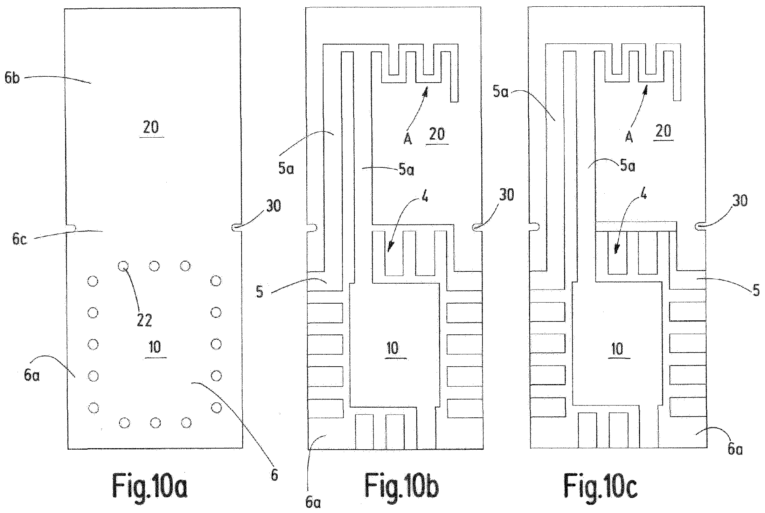

Die Ausbildung einer elektronischen Baugruppe aus einem diese Antenne A enthaltenden Gehäuse 1 und dem "primären" elektronischen Bauteil B wird nun anhand der Herstellung des Gehäuses 1 des zweiten Ausführungsbeispiels unter Bezugnahme auf die Figuren 10a bis 10e beschrieben. Die Figur 10a zeigt wiederum den Deckkörper 6 des Gehäuses 1, insoweit gleichen sich also die Herstellungsprozesse des ersten und des zweiten Ausführungsbeispiels. Die Figur 10b zeigt den Deckkörper 6 zusammen mit einem auf ihm angeordneten Leadframe 4 und die Figur 10c zeigt - entsprechend der Figur 5c - einen elektrisch aufgetrennten Leadframe 4. Man erkennt wiederum die im Boden 10 des Gehäuses 1 angeordneten Leiterbahnen 5.

Ein Vergleich der Figuren 10b und 10a mit den Figuren 5b und 5c zeigt nun, dass der Leadframe 4 des zweiten Ausführungsbeispiels nun auch Leiterbahnen 5a aufweist, welche im Deckel 20 des Gehäuses 1 verlaufen. Die Leiterbahnen 5a dienen zum Anschluss und/oder zur Ausbildung der bereits vorstehend angesprochenen, in den Figuren aber nur schematisch angedeuteten Antenne A. Man erkennt, dass die Leiterbahnen 5a eine elektrisch leitende Verbindung zwischen dem Bauteil B und der Antenne A, also einem sekundären elektronischen Bauteil, herstellen. Die Leiterbahnen 5a des Leadframes 4 verlaufen somit, ausgehend vom Deckel 20 über das Scharnierelement 30 zu den Leiterbahnen 5 des Leadframes 4 im Boden 10 des Gehäuses 1. Eine drahtlose Kommunikation des im Gehäuse 1 aufgenommenen Bauteils B über die Antenne A wird somit in einfacher Art und Weise ermöglicht.

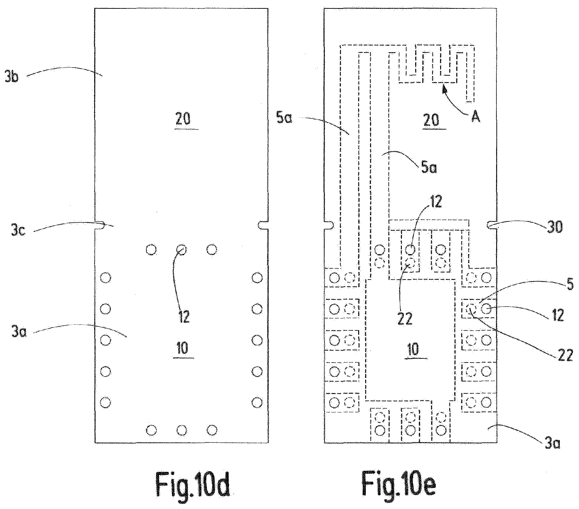

Das in den Figuren 10d und 10e gezeigte Aufbringen des Trägerkörpers 3 auf die durch den Deckkörper 6 und den Leadframe 4 mit den Leiterbahnen 5 und 5a ausgebildete Struktur entspricht wiederum demjenigen des ersten Ausführungsbeispiels (Figuren 5d und 5e), so dass eine erneute Beschreibung dieses Vorgangs nicht mehr erforderlich ist.

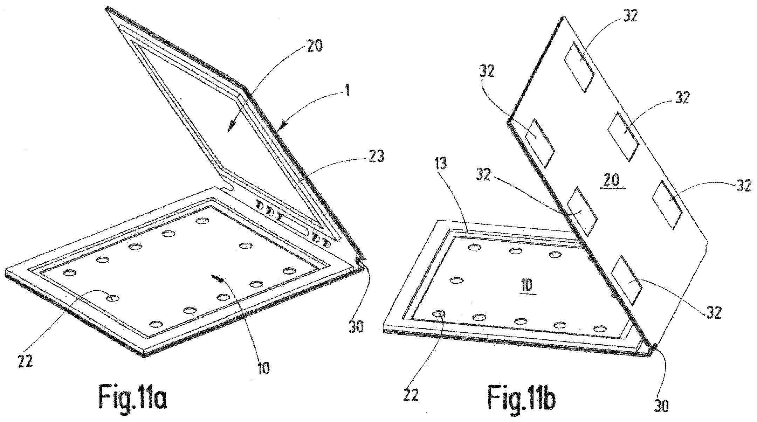

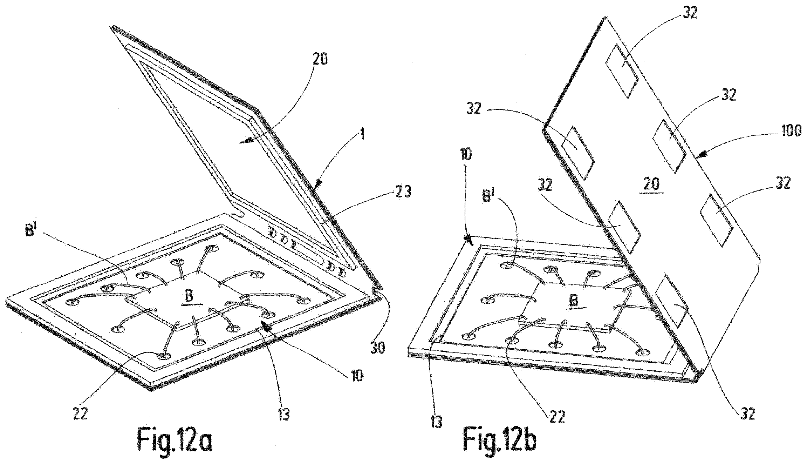

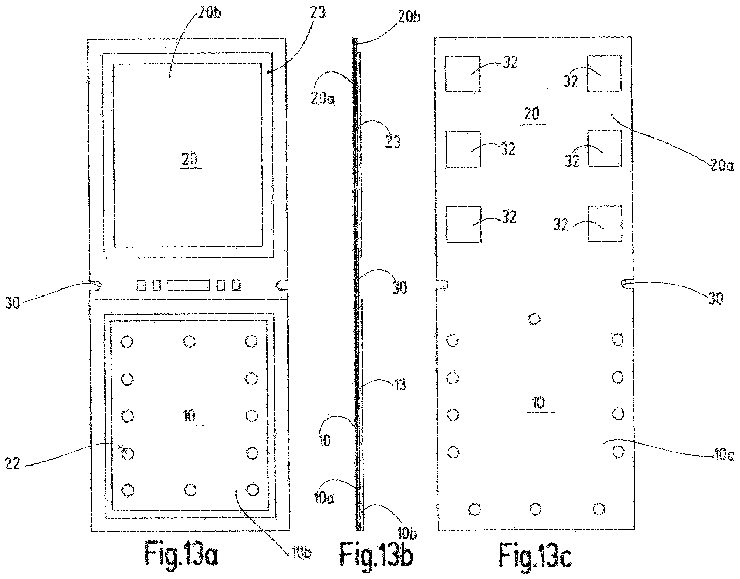

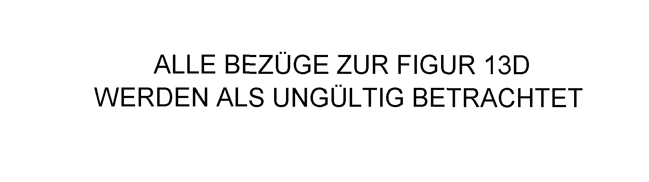

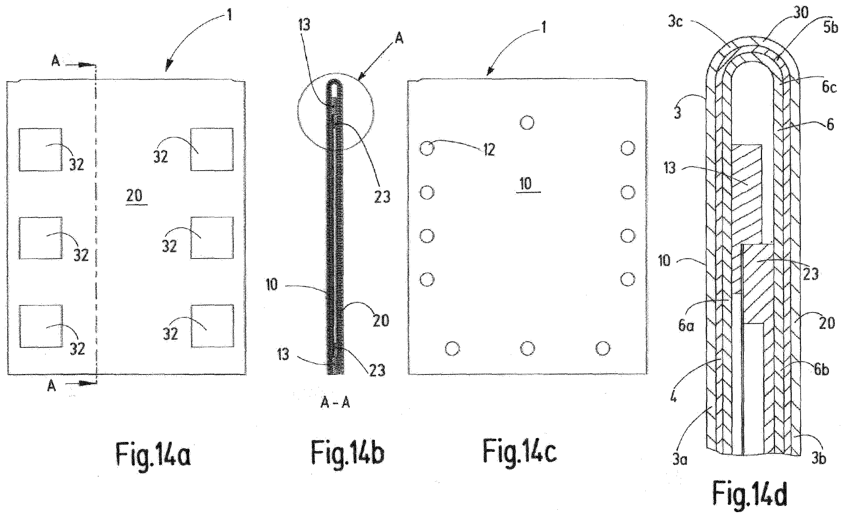

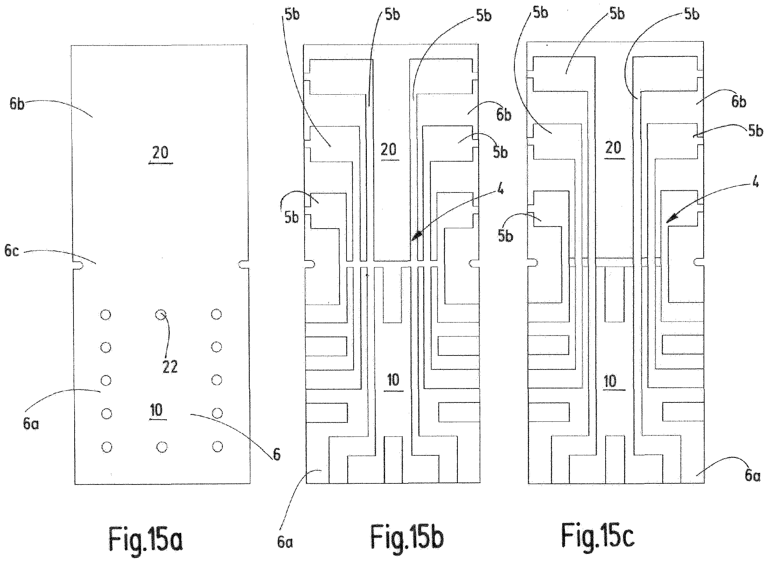

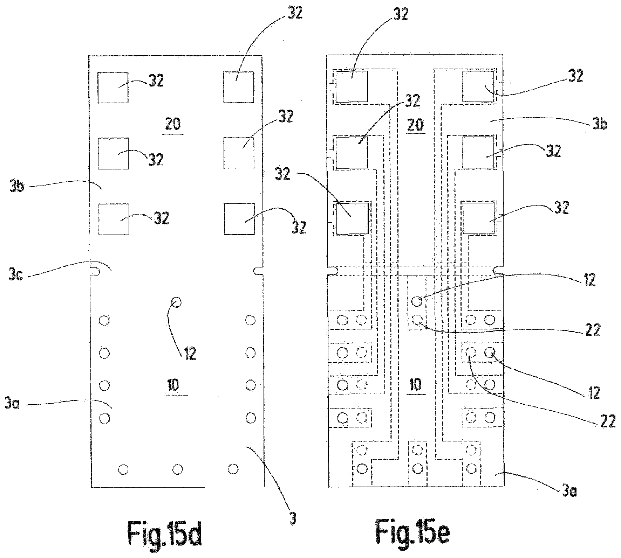

In den Figuren 11a bis 15e ist ein drittes Ausführungsbeispiel eines Gehäuses 1 für ein elektronisches Bauteil B dargestellt, das in seinem Grundaufbau nach demjenigen des ersten und des zweiten Ausführungsbeispiels entspricht, so dass korrespondierende Bauteile/Strukturen mit den gleichen Bezugszeichen versehen und nicht mehr näher beschrieben werden. Die Figuren 11a und 11b sowie 12a und 12b zeigen - entsprechend den Figuren 6a, 6b und 7a, 7b - das Gehäuse 1 ohne bzw. mit einem darin aufgenommenen elektronischen Bauteil B zur Ausbildung der elektronischen Baugruppe 100. Man erkennt, dass im Deckel 20 des Gehäuses 1 des dritten Ausführungsbeispiels - als sekundäre elektronische Bauteile - Kontaktöffnungen 32 vorgesehen sind, die - genauso wie die Kontaktöffnungen 12 im Boden 10 des Gehäuses 1 - dazu dienen, von der Oberseite 20a des Deckels 20 her einen elektrisch leitenden Kontakt mit dem im Gehäuse 1 aufgenommenen elektronischen Bauteil B herzustellen. Der in Figur 15a dargestellte Deckkörper 6 des Gehäuses 1 ist entsprechend demjenigen des ersten und des zweiten Ausführungsbeispiels ausgebildet. Man erkennt die Anschlussöffnungen 22, durch welche - wie bei den vorstehenden Ausführungsbeispielen beschrieben - durch die Bonddrähte B' mit den Leiterbahnen 5 des Leadframes 4 ein elektrischer Kontakt mit dem elektronischen Bauteil B herstellbar ist. Die Figuren 15b und 15c zeigen wiederum den auf den Deckkörper 6 aufgebrachten Leadframe 4, wobei die Leiterbahnen 5 des Leadframes 4 wiederum - wie in Figur 15c dargestellt - elektrisch getrennt wurden. Man erkennt aus der Figur 15c des weiteren, dass der Leadframe 4 nun nicht mehr - wie beim ersten Ausführungsbeispiel - nur Leiterbahnen 5 im Bereich des Bodens 10 des Gehäuses 1 aufweist, sondern dass - wie auch beim zweiten Ausführungsbeispiel - im Bereich des Deckels 20 und des Scharnierelements 30 Leiterbahnen 5b angeordnet sind. Die Leiterbahnen 5b erstrecken sich - genauso wie die Leiterbahnen 5a des zweiten Ausführungsbeispiels - ausgehend vom Deckel 20 über das Scharnierelement 30 zu den Leiterbahnen 5 des Leadframes 4 im Boden 10 des Gehäuses 1. Diese dienen zur elektrisch leitenden Verbindung des im Gehäuse 1 aufgenommenen elektronischen Bauteils B mit den entsprechenden Kontaktöffnungen 32, die Leiterbahnen 5b erstrecken sich daher von diesen Kontaktöffnungen 32 direkt oder indirekt über das Scharnierelement 30 bis zum elektronischen Bauteil B bzw. bis zu den die Anschlussöffnungen 22 durchdringenden Bonddrähten B', welche dieses elektrische Bauteil B mit dem Leadframe 4 verbinden. Insoweit entspricht die Ausbildung des Leadframes 4 demjenigen des zweiten Ausführungsbeispiels, bei dem Leiterbahnen 5a vorgesehen sind, welche das elektronische Bauteil B über das Scharnierelement 30 mit einer im Deckel 20 des Gehäuses 1 aufgenommenen Antenne A verbinden, mit der Maßgabe, dass die Leiterbahnen 5b des dritten Ausführungsbeispiels zu den Kontaktöffnungen 32 hinlaufen, so dass die Leiterbahnen 5b durch diese von außen her elektrisch kontaktierbar sind. Die Figur 15d zeigt nun den im montierten Zustand über dem Deckkörper 6 und dem Leadframe 4 liegenden Trägerkörper 3 des Gehäuses 1. Man erkennt, dass in dessen oberen Bereich 3b, welcher im montierten Zustand den Deckel 20 ausbildet, Öffnungen vorhanden sind, welche die vorstehend angesprochenen Kontaktöffnungen 32 des Deckels 20 ausbilden.

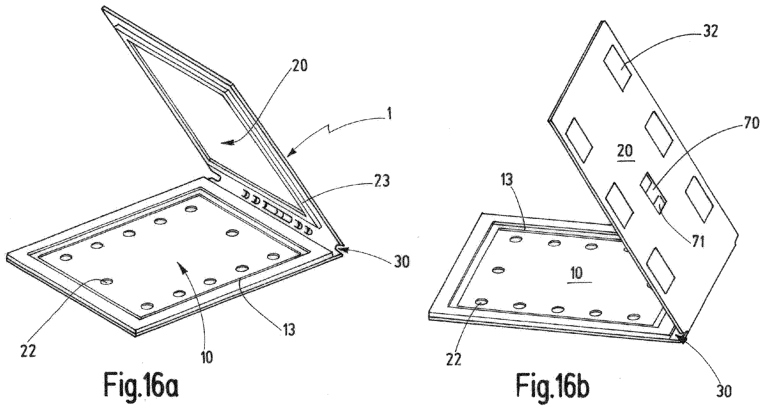

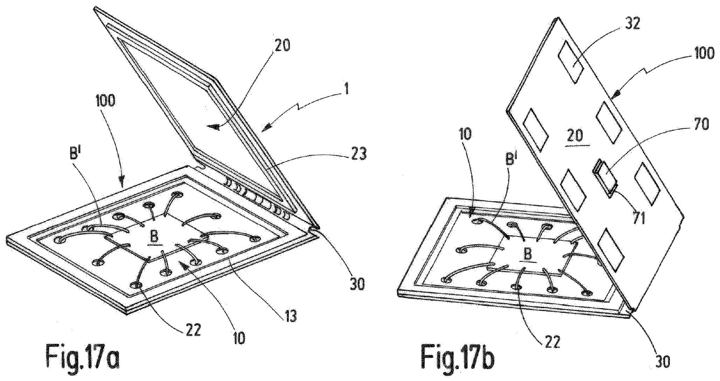

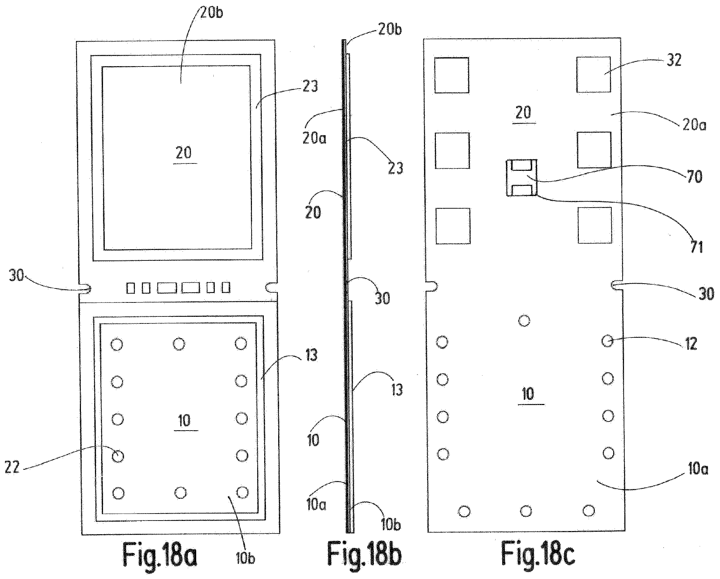

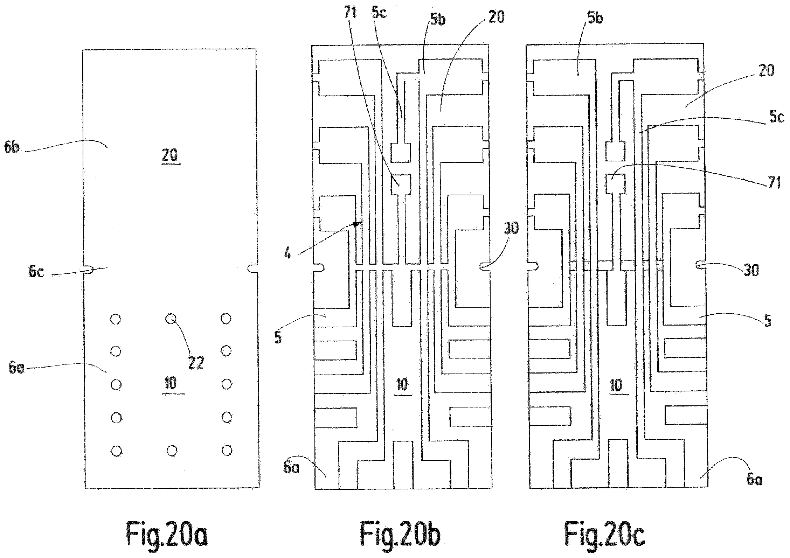

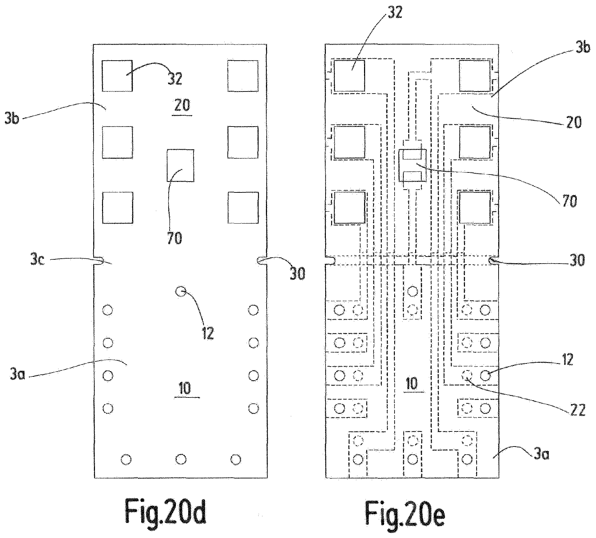

Die Figuren 16a, 16b bis 20a bis 20e zeigen nun ein viertes Ausführungsbeispiel eines Gehäuses 1 für eine elektronische Baugruppe 100, welches seinem Grundaufbau nach dem dritten Ausführungsbeispiel entspricht. Einander entsprechende Bauteile sind daher mit den gleichen Bezugszeichen versehen und müssen nicht mehr näher beschrieben werden. Der wesentliche Unterschied zwischen dem dritten und vierten Ausführungsbeispiel ist, dass das Gehäuse 1 und folglich die aus dem Gehäuse 1 und dem elektronischen Bauteil B gefertigte elektronische Baugruppe 100 im Deckel 20 nicht nur die vorstehend beschriebenen Kontaktöffnungen 32 besitzen, sondern als ein sekundäres elektronisches Bauteil noch ein Anzeigeelement 70, welches in einer Ausnehmung 71 des Deckels 20 aufgenommen ist, aufweist. Die Herstellung des Gehäuses 1 und somit des elektronischen Bauteils B ist wiederum aus den Figuren 20a bis 20e ersichtlich und entspricht der Herstellung des Gehäuses 1 des dritten Ausführungsbeispiels mit der Maßgabe, dass im Deckel 20 das Anzeigeelement 70 vorgesehen ist und somit der Leadframe 4 eine Leiterbahn 5c besitzt, die vom Boden 10 ausgehend über das Scharnierelement 30 zu diesem sekundären elektronischen Bauteil führt.

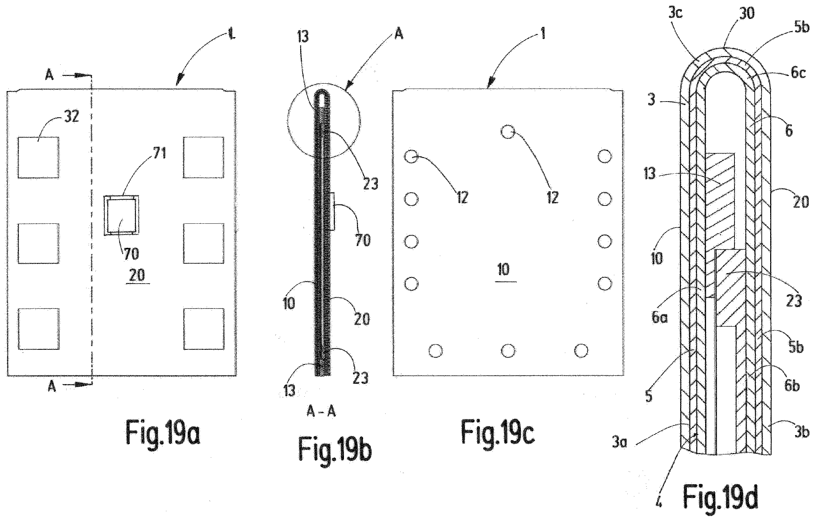

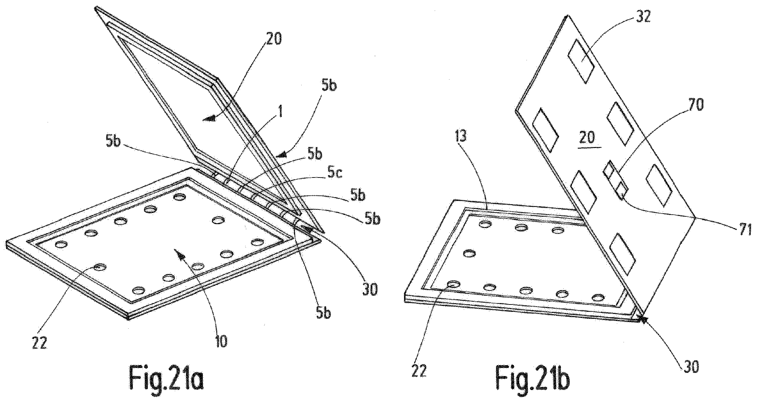

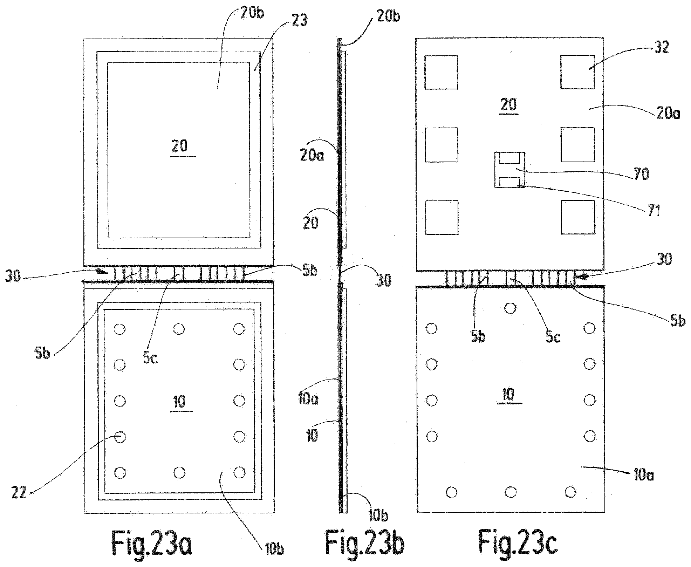

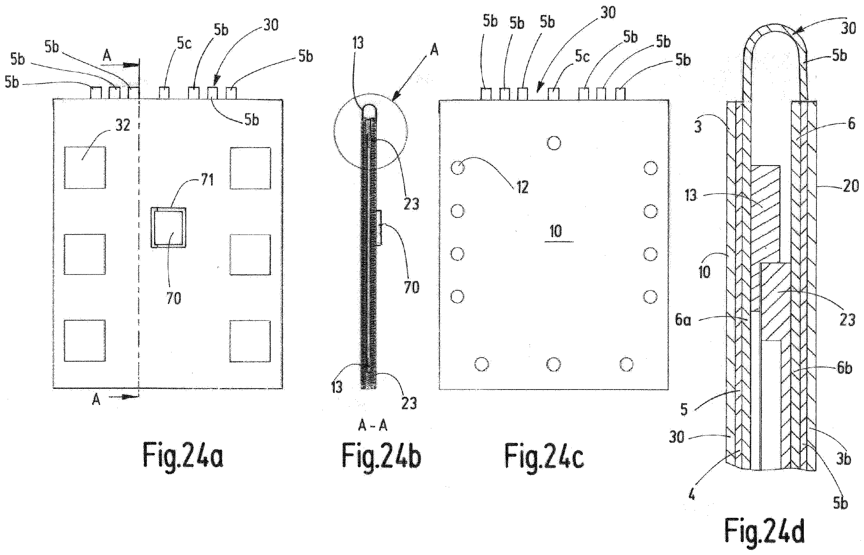

In der Figur 21a bis 25e ist nun ein fünftes Ausführungsbespiel eines Gehäuses 1 für eine elektronische Baugruppe 100 dargestellt, welches seinem Grundaufbau nach dem vierten Ausführungsbeispiel entspricht. Einander entsprechende Bauteile sind daher mit den gleichen Bezugszeichen versehen und werden nicht mehr erneut beschrieben. Der wesentliche Unterschied zwischen den beiden Ausführungsbeispielen ist nun in der Ausbildung des Schanierelements 30 zu sehen: Während beim vierten Ausführungsbeispiel vorgesehen ist, dass das Schanierelement 30 - wie am besten aus Figur 19c ersichtlich ist - durch den mittleren Bereich 3c des Trägerkörpers 3, den vom Boden 10 zum Deckel 20 führenden Leiterbahnen 5b, 5c des Leadframes 4 und dem mittleren Bereich 6c des Deckkörpers 6 ausgebildet ist, ist bei dem Schanierelement 30 des fünften Ausführungsbespiels vorgesehen, dass der Boden 10 und der Deckel 20 nur durch die Leiterbahnen 5b, 5c des Leadframes 4 verbunden sind. Bei dem fünften Ausführungsbeispiel des Gehäuses 1 entfallen somit die mittleren Bereiche 3c und 6c des Trägerkörpers 3 und des Deckkörpers 6.

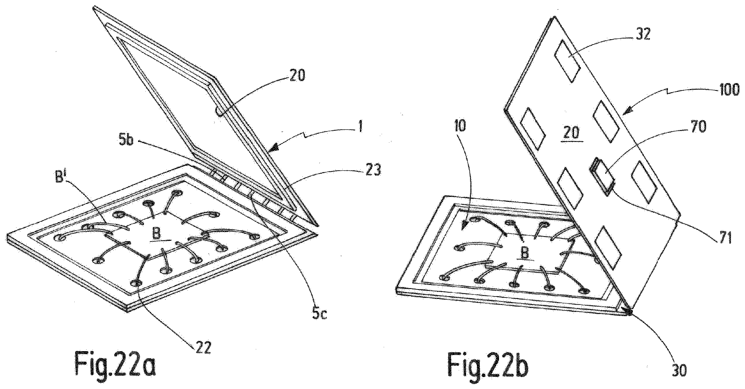

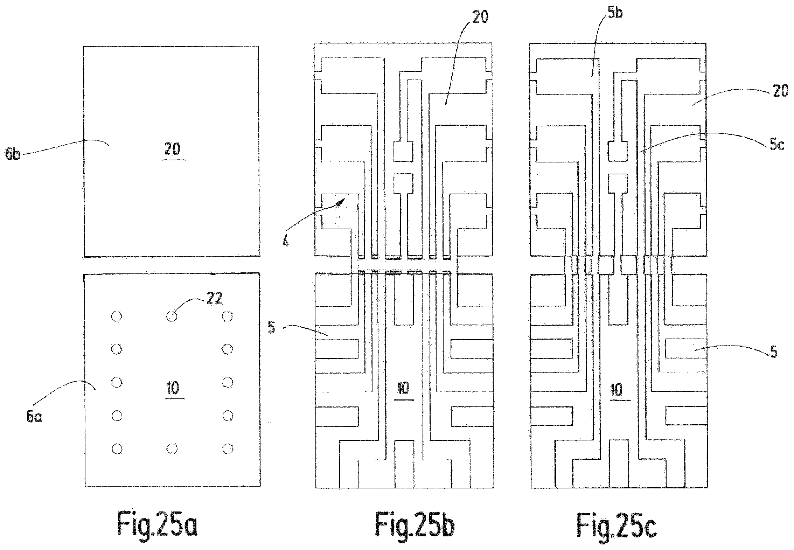

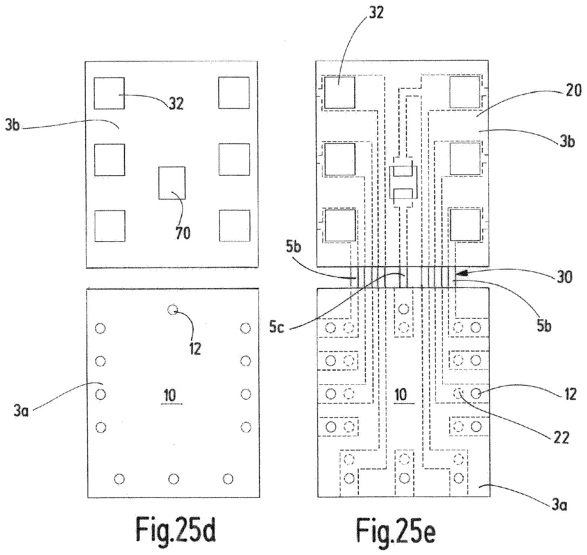

Die Herstellung des Gehäuses 1 wird anhand der Figuren 25a bis 25e beschrieben. Die Figur 25a zeigt - wie die Figur 20a beim vierten Ausführungsbeispiel - eine Draufsicht auf den Deckkörper 6; die Figur 25d zeigt - wie die Figur 20d - eine Draufsicht auf den Trägerkörper 3. Wie aus diesen Figuren klar ersichtlich ist, weist der Trägerkörper 3 nur die den Boden 10 und den Deckel 20 ausbildenden Bereiche 3a und 3b und der Deckkörper entsprechenden Bereiche 6a und 6b auf, es fehlen also die beim vierten Ausführungsbeispiel zum Schanierelement 30 gehörigen mittleren Bereiche 3c und 6c. Wie insbesondere aus den Figuren 21a und 22a ersichtlich, wird also das Schanierelement 30 beim fünften Ausführungsbeispiel durch die Leiterbahnen 5b, 5c des Leadframes 4 ausgebildet.

Wie bei den vorherig beschriebenen Ausführungsbeispielen wird auf dem Decckörper 6 der Leadframe 4 aufgelegt (Figur 25b) und die einzelnen Bereiche des Leadframes 4 werden getrennt, um Leiterbahnen 5 und 5b, 5c auszubilden, welche vom Boden 10 über das Schanierelement 30 zum Deckel 20 verlaufen. Die Leiterbahnen 5b dienen im fünften Ausführungsbeispiel - genauso wie bei vierten Ausführungsbeispiel - dazu, eine leitende elektrische Verbindung des im Gehäuse 1 aufgenommenen elektronischen Bauteils B mit einem oder mehreren der im Deckel 20 aufgenommenen sekundären elektronischen Bauteile herzustellen. Es ist ebenfalls die weitere Leiterbahn 5c vorgesehen, welche zu dem im Deckel 20 vorgesehenen Anzeigeelment 70 führt.

An dieser Stelle muss noch angemerkt werden, dass es nicht zwingend erforderlich ist, dass jede der Leiterbahnen 5b, 5c des Leadframes 4, welche das Schanierelement 30 ausbilden, eine elektrisch leitende Funktion haben muss. Es ist möglich, dass ein oder mehrere der Leiterbahnen 5b, welche - der Funktion des Schanierelements 30 entsprechen - den Boden 10 und den Deckel 20 verbinden, nicht dazu dienen, ein sekundäres Bauelement im Deckel 20 mit dem primären elektronischen Bauelement B direkt oder indirekt zu verbinden, sondern lediglich als mechanische Verbindung des Deckels 20 mit dem Boden 10 fungieren.

Die vorstehend beschriebenen Ausgestaltungen besitzen den Vorteil, dass ein durch das hier beschriebene Gehäuse 1 gehäustes elektronisches Bauteil B in einer Mehrfach-Anordnung übereinander angeordnet und nach Art eines Bus-Systems miteinander verbunden werden können.

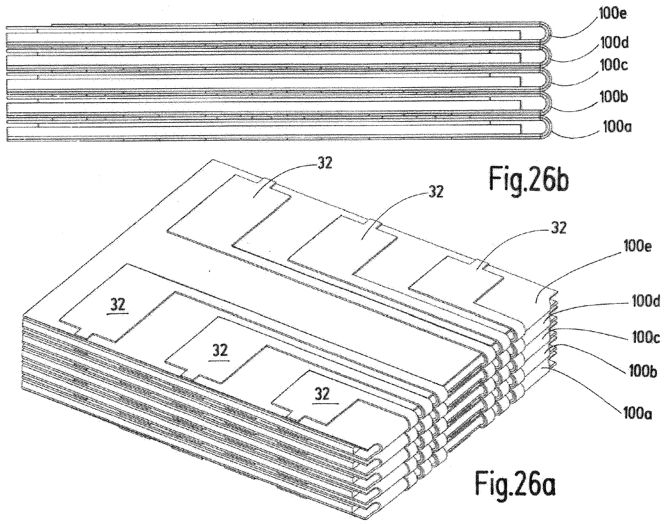

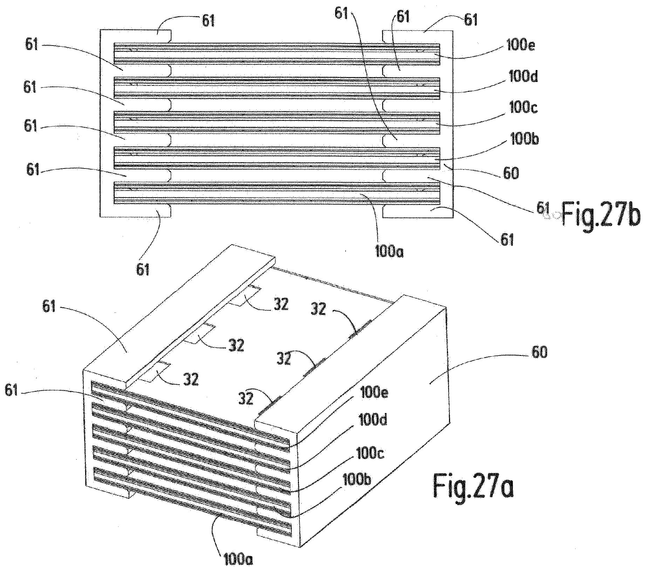

Die Figuren 26a, 26b und 27a, 27b zeigen zwei Ausführungsformen derartiger Mehrfach-Anordnungen von jeweils durch das Gehäuse 1 gehäusten elektronischen Bauteilen B. In den Figuren 16a und 16b ist eine erste aus fünf wie vorstehend beschrieben ausgebildeten elektronischen Baugruppen 100a-100e ausgebildete Mehrfach-Anordnung dargestellt. Hier sind exemplarisch vier wie vorstehend beschrieben ausgebildete elektronische Baugruppen 100a-100e übereinander gestapelt, wobei bei dieser ersten Ausführungsform die Verbindung dieser Module durch einen direkten Kontakt der Leiterbahnen 5 bzw. 5b der entsprechenden Leadframes 4 der Gehäuse 1 der elektronischen Baugruppen 100a-100e erfolgt. Hierzu wird bevorzugt, dass die Leiterbahnen 5 bzw. 5b der einzelnen Leadframes 4 jeweils im Bereich der Kontaktöffnungen 12 bzw. 32 der einzelnen Module derart ausgebildet, insbesondere geprägt sind, dass sie in diesen Bereichen die jeweiligen Trägerkörper 3 bzw. die Deckkörper 6 im Bereich dieser Kontaktöffnungen 12 bzw. 32 durchdringen, so dass durch ein Aufeinanderlegen die im Boden 10 der Gehäuse 1 benachbarter Module verlaufenden Leiterbahnen 5 der Leadframes 4 durch die Kontaktöffnungen 12 die Leiterbahnen 5b des jeweils darüber liegenden Moduls im Bereich der Kontaktöffnungen 32 elektrisch kontaktieren, so dass jeweils eine elektrisch leitende Verbindung zwischen zwei benachbarten Modulen hergestellt ist.

Durch ein entsprechendes Aufeinanderstapeln einer Anzahl von Modulen kann in einfacher Art und Weise eine multifunktionale Baugruppe herstellt werden. Als Beispiel hierfür soll ein multifunktionaler Sensor erwähnt werden, der es erlaubt, z.B. gleichzeitig die Beschleunigung, die Temperatur und einen Druck zu messen. Im derartigen Fall wird bevorzugt, dass die unterste Baugruppe 100a einer derartigen Mehrfach-Anordnung für die Kommunikation zwischen der derart aufgebauten Mehrfach-Anordnung mit einer dieser Mehrfach-Anordnung tragenden Leiterplatte sowie die Stromversorgung übernimmt. Die über der ersten elektronischen Baugruppe 100a liegende zweite elektronische Baugruppe 100b dient zur Messung der Beschleunigung und enthält als sekundäres elektronisches Bauteil einen Beschleunigungssensor. Exemplarisch dient die dritte elektronische Baugruppe 100c zum Messen einer Temperatur und enthält als sekundäres elektronisches Bauteil einen Temperatursensor. In entsprechender Art und Weise dient die vierte Baugruppe 100d zum Messen eines Druckes und enthält als sekundäres elektronisches Bauteil einen Drucksensor. Die zuoberst liegende elektronische Baugruppe 100e kann beispielsweise zur Steuerung der unter ihr liegenden Baugruppen 100a-100d dienen.

In den Figuren 27a und 27b ist eine zweite derartige Mehrfach-Anordnung ausgebildet, bei der wiederum fünf elektronische Baugruppen 100a-1 00e vorgesehen sind. Der Unterschied zwischen diesen beiden Ausführungsformen von Mehrfach-Anordnungen besteht darin, dass bei der zweiten Ausführungsform der Mehrfach-Anordnung die Baugruppen 100a-100e nicht kontaktierend übereinandergestapelt, sondern in eine Halterung 60 eingesetzt sind, welche Kontaktelemente 61 aufweist, welche mit den unteren Kontaktflächen 22 und oberen Kontaktflächen 32 eines jeden Moduls in elektrisch leitenden Kontakt treten.

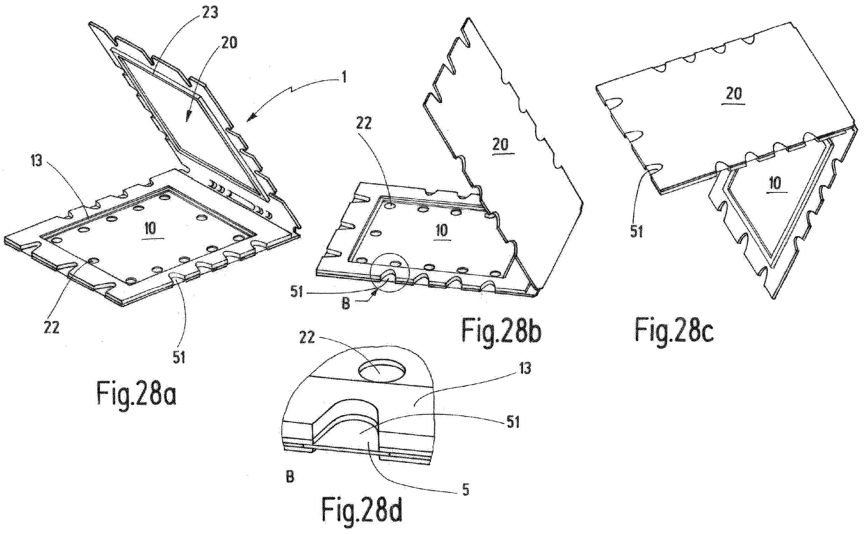

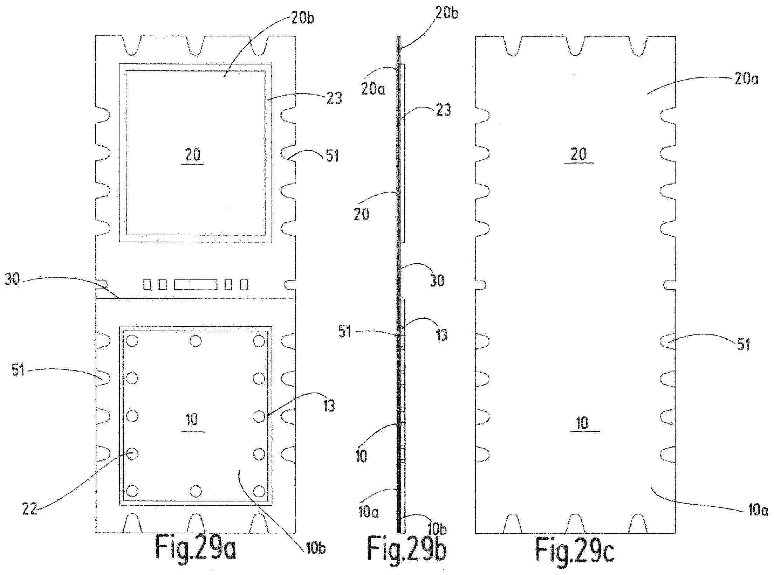

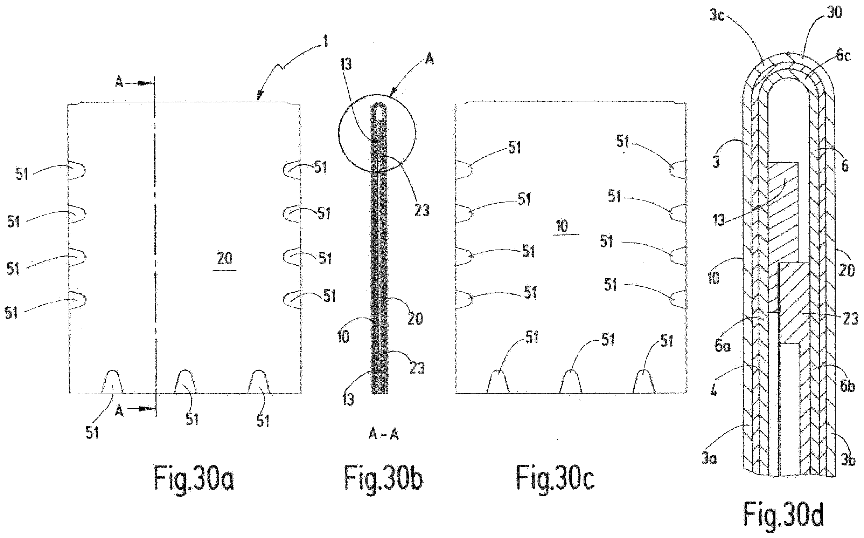

In den Figuren 28a bis 30d ist ein sechstes Ausführungsbeispiel einer derartigen elektronischen Baugruppe 100 dargestellt. Der Grundaufbau sowie die Herstellung dieser Baugruppe 100 entspricht wiederum demjenigen der ersten fünf Ausführungsbeispiele, so dass einander entsprechende Bauteile mit den gleichen Bezugszeichen versehen und nicht mehr näher beschrieben werden. Der wesentliche Unterschied zwischen dem sechsten und den vorstehend beschriebenen fünf Ausführungsbeispielen besteht in der Ausbildung der Kontaktöffnungen 12, 32. Während bei den ersten fünf Ausführungsbeispielen vorgesehen war, dass die Kontaktierung des in dem Gehäuse 1 aufgenommenen elektronischen Bauteils B zumindest durch im Boden 10 des Gehäuses 1 bzw. die im Deckel 20 des Gehäuses 1 vorhandenen Kontaktöffnungen 12, 32 erfolgt, also eine Kontaktierung von der Unterseite 1a bzw. der Oberseite 1b des Gehäuses 1 her, ist beim sechsten Ausführungsbeispiel eine seitliche Kontaktierung, also von mindestens einer der Seitenflächen 1c des Gehäuses 1, vorgesehen. Man erkennt insbesondere aus der Figur 28b sowie der eine Darstellung eines Details A der vorgenannten Figur enthaltenden Figur 28d, dass der Trägerkörper 3 und der Deckkörper 6 des Gehäuses 1 seitliche Ausnehmungen 51 aufweist, so dass in diesen Bereichen die entsprechenden Leiterbahnen 5 des Leadframes 4 nicht durch den Trägerkörper 3 und den Deckkörper 6 abgedeckt sind, so dass also die Leiterbahnen 5 des Leadframes 4 in diesen Bereichen zugänglich sind, wodurch eine elektrische Kontaktierung ausbildbar ist. In dem hier gezeigten Fall sind diese Ausnehmungen 51 sowohl im Trägerkörper 3 als auch im Deckkörper 6 vorgesehen, so dass im geschlossenen Zustand des Gehäuses 1 die Leiterbahnen 5 des Leadframes 4 von einer Seitenfläche 1c her zugänglich sind.

Dem Fachmann ist klar ersichtlich, dass es nicht zwingend ist, dass sowohl der Trägerkörper 3 als auch der Deckkörper 6 entsprechende Ausnehmungen 51 aufweist. Wenn z. B. der Deckkörper 6 keine derartigen Ausnehmungen 51 aufweist, so erlauben die Ausnehmungen 51 des Trägerkörpers 3 eine seitliche Kontaktierung und umgekehrt.

Natürlich ist es auch möglich, die vorstehend beschriebenen Maßnahmen zu kombinieren, d. h. auch bei dem sechsten Ausführungsbeispiel ergänzend zu den Ausnehmungen 51 Kontaktöffnungen 12 im Boden 10 und/oder Kontaktöffnungen 32 im Deckel 20 vorzusehen.

Dem Fachmann ist aus der vorstehenden Beschreibung klar ersichtlich, dass natürlich auch hier der Deckel 20 funktionalisierbar ist. Die zu den ersten fünf Ausführungsbeispielen gemachten diesbezüglichen Ausführungen gelten hier entsprechend.

Bei der vorstehenden Beschreibung wurde davon ausgegangen, dass der Trägerkörper 3 und der Deckkörper 6, deren Bereiche 3a, 6a bzw. 3b, 6b zusammen den Boden 10 bzw. den Deckel 20 ausbilden, aus einer einzigen Lage ausgebildet sind. Auch dies ist nicht zwingend. Vielmehr ist es möglich, den Trägerkörper 3 und/oder den Deckkörper 6 mehrlagig auszubilden.

Bei der vorstehenden Beschreibung wird des weiteren davon ausgegangen, dass der Leadframe 4 auf den Trägerkörper 3 aufgelegt wird. Auch dies ist nicht zwingend. Es ist auch möglich, dass der Leadframe 4 im Trägerkörper 3 bzw. im Deckkörper 6 aufgenommen ist, z. B. durch ein Umspritzen des Leadframes 4.

Des weiteren ist es auch denkbar, dass auf den Deckkörper 6 verzichtet wird. Der Boden 10 bzw. der Deckel 20 werden dann durch die entsprechenden Bereiche 3a bzw. 3b des Trägerkörpers 3 ausgebildet.

Ebenfalls ist denkbar, dass dieser mittlere Bereich 6c entfällt, so dass das Scharnierelement 30 nur durch den mittleren Bereich 3c des Trägerkörpers 3 ausgebildet ist. Auch die umgekehrte Variante, nämlich, dass das Scharnierelement 30 nur durch einen flexiblen Bereich 6c des Deckkörpers 6 ausgebildet ist, ist denkbar.

Bei der vorstehenden Beschreibung wird davon ausgegangen, dass das Scharnierelement 30 durch den mittleren Bereich 3c des Trägerkörpers 3 sowie die eine oder mehreren vom Deckel 20 zum Boden 10 verlaufenden Leiterbahnen 5a, 5b und/oder 5c ausgebildet sind. Auch dies ist nicht zwingend erforderlich. Es ist auch möglich, auf diesen mittleren Bereich 3c des Trägerkörpers 3 zu verzichten, so dass das Scharnierelement 30 im wesentlichen nur durch die Leiterbahnen 5a, 5b, 5c des Leadframes 4 ausgebildet ist.

Dem Fachmann ist aber aus der vorstehenden Beschreibung auch ersichtlich, dass es nicht zwingend ist, die Ränder 13 und 23 vorzusehen. Insbesondere bei flachen elektronischen Bauteilen B ist es denkbar, dass auf diese Ränder 13, 23 verzichtet wird. Um das Gehäuse 1 seitlich abzudichten, wird dann bevorzugt, dass der Deckel 20 und der Boden 10 entlang ihrer Ränder verklebt werden.

Bei der vorstehenden Beschreibung wurde davon ausgegangen, dass der Trägerkörper 3 als eine flexible Folie ausgebildet ist. Es ist aber nicht zwingend, den Trägerkörper 3 durchgehend als eine flexible Folie auszubilden. Ausreichend ist, wenn der Trägerkörper 3 wenigstens in seinem mittleren Bereich 3c, also in dem Bereich, der das Scharnierelement 30 ausbildet, derart flexibel ist, dass der Boden 10 und der Deckel 20 um dieses Scharnierelement 30 aufeinanderklappbar sind. Entsprechendes gilt für den Deckkörper 6. Auch hier ist es ausreichend, dass dieser in seinem mittleren Bereich 6c, welcher zusammen mit dem mittleren Bereich 3c des Trägerkörpers 3 das Scharnierelement 30 ausbildet, hinreichend flexibel ist.

Dem Fachmann ist aus der obigen Beschreibung ersichtlich, dass es nicht zwingend ist, dass im Gehäuse 1 lediglich ein primäres elektronisches Bauteil und/oder ein sekundäres elektronischen Bauteil vorhanden ist. Selbstverständlich ist es möglich, mehrere primäre elektronische Bauteile und/oder sekundäre elektronische Bauteile im Gehäuse 1 vorzusehen, die dann durch die Leiterbahnen 5, 5a, 5b, 5c des Leadframes 4 verbunden sind. Auch ist es möglich, dass im Gehäuse 1 elektronische Bauelemente vorhanden sind, die nicht durch den Leadframe 4 verbunden sind.

Selbstverständlich sind sämtliche der vorgenannten Maßnahmen miteinander kombinierbar.

Zusammenfassend ist festzuhalten, dass durch die beschriebenen Maßnahmen ein Gehäuse 1 ausgebildet wird, welches in einfacher Art und Weise eine Verkapselung eines elektronischen Bauteils ermöglicht. Von Vorteil ist, dass das Gehäuse 1 eine Funktionalisierung des Deckels 20 und/oder des Bodens 10 des Gehäuses 1 ermöglicht, so dass im Deckel 20 und/oder im Boden 10 sekundäre elektronische Bauteile wie eine Antenne, Sensoren, Anzeigeelemente, Kontaktelemente, etc., vorgesehen werden können, welche mit dem im Gehäuse 1 aufgenommenen elektronischen Bauteil B zusammenwirken. Durch das Vorsehen von Kontaktflächen 32 im Deckel 20 des Gehäuses 1 und/oder an mindestens einer der Seitenflächen 1c desselben wird in einfacher Art und Weise erreicht, dass mehrere aus einem Gehäuse 1 und einem darin aufgenommenen elektronischen Bauteil zusammengesetzte elektronische Baugruppen 100, 100a-100e übereinander bzw. seitlich nebeneinander angeordnet werden können, wobei insbesondere die Übereinander-Anordnung mehrerer wie vorstehend beschrieben ausgebildeter elektronischer Baugruppen 100, 100a-100e eine erhöhte Bauteildichte auf einer diese elektronischen Baugruppen 100, 100a-100e aufnehmenden elektronischen Leiterplatte ermöglicht.

## Patentansprüche

1. Gehäuse zur Aufnahme eines **primären** elektronischen Bauteils (B) einer elektronischen Baugruppe (100, 100a-100e), wobei das Gehäuse (1) einen Boden (10) und einen Deckel (20) aufweist, wobei der Boden (10) und der Deckel (20) durch ein Scharnierelement (30) miteinander verbunden und der Boden (10) und der Deckel (20) des Gehäuses (1) über das Scharnierelement (30) aufeinander klappbar sind, wobei im Gehäuse (1) mindestens ein Leiterbahnen (5; 5a; 5b; 5c) aufweisender Leadframe (4) angeordnet ist, wobei mindestens eine Leiterbahn (5) des Leadframes (4) im Boden (10) des Gehäuses (1) und mindestens eine weitere Leiterbahn (5a; 5b; 5c) im Deckel (20) des Gehäuses (1) angeordnet ist, und wobei sich die mindestens eine weitere Leiterbahn (5a; 5b; 5c) vom Boden (10) des Gehäuses (1) ausgehend über das Scharnierelement (30) bis zum Deckel (20) des Gehäuses (1) erstreckt, wobei zur Abdichtung des Gehäuses (1) in seinem Seitenbereich der Boden (10) einen an seiner Oberseite (10a) angeordneten umlaufenden Rand (13) und der Deckel (20) des Gehäuses (1) einen an seiner Unterseite (20b) angeordneten umlaufenden weiteren Rand (23) besitzt, so dass, wenn das Gehäuse (1) geschlossen wird, indem der Deckel (20) um das Scharnierelement (30) geklappt wird, der umlaufende Rand (13) des Bodens (10) und der umlaufende Rand (23) des Deckels (20) miteinander in Kontakt treten, wodurch eine Abdichtung des Gehäuses (1) in seinem Seitenbereich erzielt ist, **wobei das Gehäuse (1) mindestens ein sekundäres elektronisches Bauteil enthält, dadurch gekennzeichnet, dass das mindestens eine sekundäre Bauteil** im Deckel (20) und/oder im Boden (10) des Gehäuses (1) angeordnet ist.

2. Gehäuse nach Anspruch 1, **dadurch gekennzeichnet, dass** das Gehäuse (1) mindestens einen Trägerkörper (3) aufweist, dessen erster Bereich (3a) den Boden (10) und dessen zweiter Bereich (3b) den Deckel (20) des Gehäuses (1) ausbilden.

3. Gehäuse nach Anspruch 2, **dadurch gekennzeichnet, dass** der Trägerkörper (3) einen zwischen dem ersten Bereich (3a) und dem zweiten Bereich (3b) liegenden mittleren Bereich (3c) aufweist, wobei der Trägerkörper (3) zumindest in seinem mittleren Bereich (3c) flexibel ausgebildet ist.

4. Gehäuse nach einem der Ansprüche 2 oder 3, **dadurch gekennzeichnet, dass** über dem Trägerkörper (3) ein Deckkörper (6) angeordnet ist, dessen erster Bereich (6a) zusammen mit dem ersten Bereich (3a) des Trägerkörpers (3) den Boden (10) des Gehäuses (1), und dessen zweiter Bereich (6b) zusammen mit dem zweiten Bereich (3b) des Trägerkörpers (3) den Deckel (20) ausbildet.

5. Gehäuse nach Anspruch 4, **dadurch gekennzeichnet, dass** der Deckkörper (6) einen zwischen dem ersten Bereich (6a) und dem zweiten Bereich (6b) angeordneten mittleren Bereich (6c) aufweist.

6. Gehäuse nach einem der vorangehenden Ansprüche, **dadurch gekennzeichnet, dass** das Scharnierelement (30) mindestens eine Leiterbahn (5a; 5b; 5c) aufweist.

7. Gehäuse nach einem der Ansprüche 2 bis 5, **dadurch gekennzeichnet, dass** der Trägerkörper (3) und/oder der Deckkörper (6) mehrlagig ausgebildet ist.

8. Gehäuse nach einem der vorangehenden Ansprüche, **dadurch gekennzeichnet, dass** der Boden (10) und/oder der Deckel (20) mindestens eine Kontaktöffnung (12; 32) besitzen, über die ein im Gehäuse (1) aufgenommenes elektronisches Bauteil (B) elektrisch kontaktierbar ist.

9. Elektronische Baugruppe, enthaltend mindestens ein **primäres** elektronisches Bauteil (B), das in einem Gehäuse (1) aufgenommen ist, **dadurch gekennzeichnet, dass** das Gehäuse (1) nach einem der Ansprüche 1 bis 8 ausgebildet ist.

10. Elektronische Baugruppe nach Anspruch 9, **dadurch gekennzeichnet, dass** dieses mindestens eine primäre elektronische Bauteil (B) im Boden (10) und/oder im Deckel (20) angeordnet ist, und dass dieses mindestens eine primäre elektronische Bauteil (B) und das mindestens eine sekundäre elektronische Bauteil durch Leiterbahnen (5; 5a; 5b; 5c) des im Gehäuse (1) angeordneten Leadframes (4) verbunden sind.

11. Verfahren zur Herstellung eines Gehäuses (1) nach einem der Ansprüche 1 bis 8 für eine elektronische Baugruppe (100; 100a-100e), wobei zur Herstellung des Gehäuses (1) ein Trägerkörper (3) verwendet wird, der einen ersten Bereich (3a) und einen zweiten Bereich (3b) aufweist, und wobei auf oder in diesem Trägerkörper (3) ein Leadframe (4) angeordnet wird, **dadurch gekennzeichnet, dass** an einer Oberseite (10a) des Bodens (10) und an einer Unterseite (20a) des Deckels (20) ein umlaufender Rand (13, 23) angebracht wird, so dass, wenn das Gehäuse (1) geschlossen wird, indem der Deckel (20) um das Scharnierelement (30) geklappt wird, der umlaufende Rand (13) des Bodens (10) und der umlaufende Rand (23) des Deckels (20) miteinander in Kontakt treten, wodurch eine Abdichtung des Gehäuses (1) in seinem Seitenbereich erzielt ist.

12. Verfahren nach Anspruch 11, **dadurch gekennzeichnet, dass** der Trägerkörper einen zwischen dem ersten Bereich (3a) und dem zweiten Bereich (3b) liegenden mittleren Bereich (3c) aufweist, und dass der Trägerkörper (3) zumindest in diesem mittleren Bereich (3c) flexibel ausgebildet ist.

13. Verfahren nach einem der Ansprüche 11 oder 12, **dadurch gekennzeichnet, dass** über dem Trägerkörper (3) und dem darauf oder darin angeordneten Leadframe (4) ein Deckkörper (6) angeordnet wird, der einen ersten Bereich (6a) und einen zweiten Bereich (6b) sowie vorzugsweise einen zwischen diesen beiden Bereichen (6a, 6b) liegenden flexiblen mittleren Bereich (6c) aufweist.

14. Verfahren zur Herstellung einer elektronischen Baugruppe, bei dem zur Ausbildung einer gehäusten elektronischen Baugruppe ein **primäres** elektronisches Bauteil (B) in ein Gehäuse (1) eingesetzt wird, **dadurch gekennzeichnet, dass** ein Gehäuse (1) nach einem der Ansprüche 1 bis 8 verwendet wird.

## Claims

1. Housing for accommodating an electronic component (B) of an electronic module (100, 100a-100e), whereby the housing (1) comprises a bottom part (10) and a cover part (20), whereby the bottom part (10) and the cover part (20) are connected by a hinge member (30) and the bottom part (10) and the cover part (20) of the housing (1) can be folded onto each other by the hinge member (30), whereby in the housing (1) at least one lead frame (4) comprising conductor paths (5; 5a; 5b; 5c) is arranged, wherein at least one conductor path (5) of the lead frame (4) is provided in the bottom part (10) of the housing (1) and at least one further conductor path (5a; 5b; 5c) is provided in the cover part (20) of the housing (1), and wherein said at least one further conductor path (5a; 5b; 5c) extends from the bottom part (10) of the housing (1) via the hinge member (30) to the cover part (20) of the housing (1), whereby the bottom part (10) comprises a circumferential rim (13) arranged on its top side (10a) and the cover part (20) of the housing (1) comprises on its underside (20b) a circumferential further rim (23), so that, when the housing (1) is closed by folding the cover part (20) around the hinge member (30), the circumferential rim (13) of the bottom part (10) and the circumferential rim (23) of the cover part (20) enter in contact with each other, so that a sealing of the housing (1) in its side portion is achieved, whereby the housing (1) comprises at least one secondary electronic component (B), **characterized in that** said at least one secondary electronic component (B) is provided in the cover part (20) and/or in the bottom part (10) of the housing (1).

2. Housing according to claim 1, **characterized in that** the housing (1) comprises at least one carrier body (3), having a first portion (3a) and a second portion (3b), said first portion (3a) forming the bottom part (10) and said second portion (3b) forming the cover part (20) of the housing (1).

3. Housing according to claim 2, **characterized in that** the carrier body (3) comprises a central portion (3c) arranged between the first portion (3a) and the second portion (3b), wherein said carrier body (3) is formed flexible at least in its central portion (3c).

4. Housing according to one of the claims 2 or 3, **characterized in that** above the carrier body (3) a cover body (6) is arranged, whose first portion (6a) together with the first portion (3a) of the carrier body (3) forms the bottom part (10) of the housing (1), and whose second portion (6b) together with the second portion (3b) of the carrier body (3) forms the cover part (20).

5. Housing according to claim 4, **characterized in that** the cover body (6) comprises a central portion (6c) arranged between the first portion (6a) and the second portion (6b).

6. Housing according to one of the previous claims, **characterized in that** the hinge member (30) comprises at least one conductor path (5a; 5b; 5c).

7. Housing according to one of the claims 2 to 5, **characterized in that** at least one of the carrier body (3) and the cover body (6) is formed multi-layered.

8. Housing according to one of the previous claims, **characterized in that** of the bottom part (10) and/or the cover part (20) comprises at least one contact opening (12; 32), by which an electronic component (B) accommodated in the housing (1) can be electrically contacted.

9. Electronic module, comprising at least one primary electronic component (B), which is accommodated in a housing (1), **characterized in that** the housing (1) is formed according to one of the claims 1 to 8.

10. Electronic module according to claim 9, **characterized in that** said at least one primary electronic component (B) is provided onto the bottom part (10) and/or the cover part (20), and that said at least one primary electronic component (B) and said at least one secondary electronic component are connected via conductor paths (5; 5a; 5b; 5c) of the lead frame (4) provided in the housing (1).

11. Method for manufacturing a housing (1) according to one of the claims 1 to 8, for an electronic module (100; 100a-100e), whereby for manufacturing said housing (1) a carrier body (3) is used, which has a first portion (3a) and a second portion (3b), and that on or in said carrier body (3) a lead frame (4) is arranged, **characterized in that** on the top side (10a) of the bottom part (10) and on the underside (20b) of the cover part (20) a circumferential rim (13, 23) is arranged, so that, when the housing (1) is closed by folding the cover part (20) around the hinge member (30), the circumferential rim (13) of the bottom part (10) and the circumferential rim (23) of the cover part (20) enter in contact with each other, whereby a sealing of the housing (1) in its side portion is achieved.

12. Method according to claim 11, **characterized in that** the carrier body (3) comprises a central portion (3c) being arranged between the first portion (3a) and the second portion (3b), and that the carrier body (3) is provided flexible at least in said central portion (3c).

13. Method according to one of the claims 11 or 12, **characterized in that** above the carrier body (3) and the lead frame (4) being arranged on or in it a cover body (6) is provided, which has a first portion (6a) and a second portion (6b) as well preferably a flexible central portion (6c) being arranged between said portions (6a, 6b).

14. Method for manufacturing an electronic module, in which for forming a housed electronic module a primary electronic component (B) is inserted into a housing (1), **characterized in that** a housing (1) according to one of the claims 1 to 8 is used.

## Revendications

1. Boîtier pour recevoir un composant électronique primaire (B) d'un module électronique (100, 100a - 100e), dans lequel le boîtier (1) présente un fond (10) et un couvercle (20), dans lequel le fond (10) et le couvercle (20) sont reliés l'un à l'autre par un élément formant charnière (30) et le fond (10) et le couvercle (20) du boîtier (1) peuvent être rabattus l'un sur l'autre par l'intermédiaire de l'élément formant charnière (30), dans lequel au moins un cadre conducteur (4) présentant des pistes conductrices (5 ; 5a ; 5b ; 5c) est disposé dans le boîtier (1), dans lequel au moins une piste conductrice (5) du cadre conducteur (4) est disposée dans le fond (10) du boîtier (1) et au moins une autre piste conductrice (5a ; 5b ; 5c) est disposée dans le couvercle (20) du boîtier (1), et dans lequel l'au moins une autre piste conductrice (5a ; 5b ; 5c) s'étend en partant du fond (10) du boîtier (1) jusqu'au couvercle (20) du boîtier (1) en passant par l'élément formant charnière (30), dans lequel pour étanchéifier le boîtier (1) dans sa zone latérale, le fond (10) possède un bord périphérique (13) disposé sur son côté supérieur (10a) et le couvercle (20) du boîtier (1) possède un autre bord périphérique (23) disposé sur son côté inférieur (20b) de sorte que, quand le boîtier (1) est fermé en ce que le couvercle (20) est rabattu autour de l'élément formant charnière (30), le bord périphérique (13) du fond (10) et le bord périphérique (23) du couvercle (20) entrent en contact l'un avec l'autre, ce qui permet d'obtenir une étanchéification du boîtier (1) dans sa zone latérale, dans lequel le boîtier (1) contient au moins un composant électronique secondaire, **caractérisé en ce que** l'au moins un composant secondaire est disposé dans le couvercle (20) et/ou dans le fond (10) du boîtier (1) .

2. Boîtier selon la revendication 1, **caractérisé en ce que** le boîtier (1) présente au moins un corps de support (3), dont la première zone (3a) réalise le fond (10) et dont la deuxième zone (3b) réalise le couvercle (20) du boîtier (1).

3. Boîtier selon la revendication 2, **caractérisé en ce que** le corps de support (3) présente une zone centrale (3c) située entre la première zone (3a) et la deuxième zone (3b), dans lequel le corps de support (3) est réalisé de manière flexible au moins dans sa zone centrale (3c).

4. Boîtier selon l'une quelconque des revendications 2 ou 3, **caractérisé en ce qu'**est disposé au-dessus du corps de support (3) un corps couvrant (6), dont la première zone (6a) réalise conjointement avec la première zone (3a) du corps de support (3) le fond (10) du boîtier (1) et dont la deuxième zone (6b) réalise conjointement avec la deuxième zone (3b) du corps de support (3) le couvercle (20).

5. Boîtier selon la revendication 4, **caractérisé en ce que** le corps couvrant (6) présente une zone centrale (6c) disposée entre la première zone (6a) et la deuxième zone (6b).

6. Boîtier selon l'une quelconque des revendications précédentes, **caractérisé en ce que** l'élément formant charnière (30) présente au moins une piste conductrice (5a ; 5b ; 5c).

7. Boîtier selon l'une quelconque des revendications 2 à 5, **caractérisé en ce que** le corps de support (3) et/ou le corps couvrant (6) sont réalisés avec plusieurs couches.

8. Boîtier selon l'une quelconque des revendications précédentes, **caractérisé en ce que** le fond (10) et/ou le couvercle (20) possèdent au moins une ouverture de contact (12 ; 32), par l'intermédiaire de laquelle un composant électronique (B) logé dans le boîtier (1) peut être mis en contact électrique.

9. Module électronique contenant au moins un composant électronique primaire (B), qui est logé dans un boîtier (1), **caractérisé en ce que** le boîtier (1) est réalisé selon l'une quelconque des revendications 1 à 8.

10. Module électronique selon la revendication 9, **caractérisé en ce que** ledit au moins un composant électronique primaire (B) est disposé dans le fond (10) et/ou dans le couvercle (20), et que ledit au moins un composant électronique primaire (B) et l'au moins un composant électronique secondaire sont reliés par des pistes conductrices (5 ; 5a ; 5b ; 5c) du cadre conducteur (4) disposé dans le boîtier (1).

11. Procédé pour fabriquer un boîtier (1) selon l'une quelconque des revendications 1 à 8 pour un composant électronique (100 ; 100a - 100e), dans lequel est utilisé, pour fabriquer le boîtier (1), un corps de support (3) qui présente une première zone (3a) et une deuxième zone (3b), et dans lequel un cadre conducteur (4) est disposé sur ou dans ledit corps de support (3), **caractérisé en ce qu'**un bord périphérique (13, 23) est installé sur un côté supérieur (10a) du fond (10) et sur un côté inférieur (20a) du couvercle (20) de sorte que dans le boîtier (1) est fermé **en ce que** le couvercle (20) est rabattu autour de l'élément formant charnière (30), le bord périphérique (13) du fond (10) et le bord périphérique (23) du couvercle (20) entrent en contact l'un avec l'autre ce qui permet d'obtenir une étanchéification du boîtier (1) dans sa zone latérale.

12. Procédé selon la revendication 11, **caractérisé en ce que** le corps de support présente une zone centrale (3c) située entre la première zone (3a) et la deuxième zone (3b), et que le corps de support (3) est réalisé de manière flexible au moins dans ladite zone centrale (3c) .

13. Procédé selon l'une quelconque des revendications 11 ou 12, **caractérisé en ce qu'**est disposé, au-dessus du corps de support (3) et du cadre conducteur (4) disposé sur ou dans celui-ci, un corps couvrant (6), qui présente une première zone (6a) et une deuxième zone (6b) ainsi que de préférence une zone centrale (6c) flexible située entre lesdites deux zones (6a, 6b).

14. Procédé pour fabriquer un module électronique, où pour réaliser un module électronique abrité, un composant électronique primaire (B) est inséré dans un boîtier (1), **caractérisé en ce qu'**un boîtier (1) selon l'une quelconque des revendications 1 à 8 est utilisé.
